# EUROPEAN PATENT APPLICATION

(11) **EP 1 513 016 A2**
(43) Date of publication of application: **09.03.2005**
(21) Application number: 04021306.8
(22) Date of filing: 08.09.2004
(51) Int. Cl.: G03F 7/11, B41C 1/10, B41M 5/40

(54) **Image recording material and planographic printing plate**

(30) Priority: 08.09.2003 JP 2003315290; 15.04.2004 JP 2004120694
(71) Applicant: Fuji Photo Film Co., Ltd., Kanagawa 250-0123 (JP)
(72) Inventor: Kawauchi, Ikuo, Yoshida-cho, Haibara-gun, Shizuoka (JP); Imai, Masako, Yoshida-cho, Haibara-gun, Shizuoka (JP); Takahashi, Miki, Yoshida-cho, Haibara-gun, Shizuoka (JP)
(74) Representative: HOFFMANN - EITLE

(57) **Abstract**

The present invention provides an image recording material comprising a substrate, an intermediate layer, and a photosensitive layer containing a novolac phenol resin and a light to heat conversion agent and being recordable with an infrared laser. The intermediate layer and photosensitive layer are sequentially provided on the substrate. The intermediate layer contains a polymer having an acidic group and being capable of interacting with the novolac phenol resin contained in the photosensitive layer. A planographic printing plate excellent in chemical resistance and printing durability is obtained by heat-treating the image recording material at 150 to 300°C after effecting image-wise exposure with an infrared laser and development.

## Description

### BACKGROUND OF THE INVENTION

### Field of the Invention

The present invention relates to a positive type photosensitive composition, the solubility of which, in an aqueous alkaline solution, is enhanced by being exposed to infrared rays. More specifically, the invention relates to a positive type photosensitive composition useful as a recording layer of a planographic printing plate precursor that can be subjected to the so-called direct plate-making method, according to which a printing plate can be directly made up by scanning of an infrared laser on the basis of digital signals received from a computer or the like.

### Description of the Related Art

Hitherto, various photosensitive compositions have been used for the formation of visible images, or as a material for planographic printing plate precursors. Recently, remarkable developments have taken place in the area of lasers for planographic printing. With particular, regard to both solid lasers and semiconductor lasers having an emission wavelength within a near infrared or infrared wavelength range, it has become easy to obtain lasers which have a high level of output and which are at the same time compact. These lasers are extremely useful as light sources for exposure when printing plates are made up directly on the basis of digital data received from a computer or the like.

Materials which can be used for positive type planographic printing plate precursors applicable for infrared lasers include, as essential components, a binder resin soluble in an aqueous alkaline solution (hereinafter referred to where appropriate as an "alkali-soluble resin"), and an infra red dye which absorbs light to generate heat. When an image is formed in a positive type planographic printing plate precursor, the infra red dye interacts with the binder resin in its unexposed portions (image portions) so as to function as a dissolution inhibitor which can substantially reduce the solubility of the binder resin. On the other hand, in its exposed portions (non-image portions), interaction of the infra red dye with the binder resin is weakened by the heat generated. Consequently, an exposed portion can turn into a state in which it can be dissolved in an alkaline developer, so that an image is formed thereon.

However, insofar as infrared-laser-applicable positive planographic printing plate precursor materials are concerned, differences in the degree of resistance against dissolution in a developer between unexposed portions (image portions) and exposed portions (non-image portions) therein, that is, differences in development latitude have not yet been sufficient under various conditions of use. Thus, problems have occurred insofar that, with changes in conditions of use of materials, materials have tended to be either excessively developed or inadequately developed.

Further, in the image-forming portion, the IR dye or the like only serves as a dissolution inhibitor to the un-exposed portion (the image-forming portion) and the strength of the image-forming portion is not particularly improved by the IR dye in the image formation mechanism. Therefore, attempts are being made to select suitable polymers in order to obtain sufficient strength of the image-forming portion. For example, a technique to use novolak resin as a main binder has been proposed (refer to, for example, Japanese Patent Application Laid-Open (JP-A) No. 10-268512), whereby the printing durability is improved by carrying out burning treatment. However, the recording layer has another problem in that it is inferior in chemical resistance.

On the other hand, from the viewpoint of improving the chemical resistance of the recording layer, an image recording material using a sulfonamide based copolymer having a specific structure as a binder polymer has been proposed (e.g., JP-A No. 11-44956). For this type of polymer, although printing durability is observed if a cleaner is used, the printing durability cannot be improved by burning treatment. If the burning treatment is not carried out (even if the composition of the binder polymer is changed), the printing durability will be insufficient and therefore, adequacy in both chemical resistance and printing durability cannot be obtained at the same time.

Accordingly, attempts are being made to improve the printing durability by forming a predetermined intermediate layer between a support and a recording layer. There is disclosed a case in which an intermediate layer containing a copolymer of a carboxylic acid group-containing monomer and an onium salt-containing monomer is provided on a support which has been subjected to hydrophilization with a silicate (e.g., JP-A No. 2000-108538). According to this method, although printing durability and staining resistance of the non-image-forming portion are improved, chemical resistance is still insufficient. Therefore, there has been a strong desire for an image recording material having excellent chemical resistance and also having printing durability considerably improved by the burning treatment. Hereinafter, the excellent printing durability obtained by the burning treatment may be referred to as "printing durability by burning" in some cases.

### SUMMARY OF THE INVENTION

In consideration of the disadvantages of the above-mentioned prior arts, the present invention provides an IR laser applicable image recording material having excellent printing durability of an image-forming portion (which printing durability is remarkably improved by burning) and excellent chemical resistance.

The present inventors have found, through intensive studies, that the problems above can be solved by using a polymer compound having a specific functional group at a side chain thereof in an intermediate layer, and have completed the present invention.

The image recording material of the invention comprises a substrate, an intermediate layer, and a photosensitive layer containing a novolac phenol resin and a light to heat conversion agent and being recordable with an infrared laser. The intermediate layer and photosensitive layer are sequentially provided on the substrate, and the intermediate layer contains a polymer having an acidic group and being able to interact with a novolac phenol resin contained in the photosensitive layer.

The planographic printing plate of the invention is obtained by heat-treating a planographic printing plate precursor at 150 to 300°C after effecting exposure with an infrared laser and developing thereto, which planographic printing plate precursor comprises the substrate, intermediate layer, and a photosensitive layer containing novolac phenol resin and light to heat conversion agent and being recordable with an infrared laser. The intermediate layer and photosensitive layer are sequentially provided on the substrate, and the intermediate layer contains a polymer having an acidic group and being able to interact with the novolac phenol resin contained in the photosensitive layer.

While the phrase "sequentially provide" as used herein refers to providing the intermediate layer and photosensitive layer on the substrate in this order, other layers (for example, a protective layer and back-coat layer) may further be provided according to necessity.

While the function of the invention is not clear, it may be conjectured as follows.

The polymer contained in the intermediate layer of the present invention (which will simply be referred to as the "specific polymer" hereinafter) has acidic groups, and is able to interact with the novolac phenol resin (which will simply be referred to as a "novolac resin" hereinafter) contained in the photosensitive layer provided adjacent to the intermediate layer. The polymer is able to strongly interact with the surface of the substrate by the function of the acidic group, and is also able to interact with the photosensitive layer due to the physical properties thereof. Consequently, the photosensitive layer is tightly adhered on the substrate via the intermediate layer, and is considered to be improved in printing durability. In addition, since the polymers constituting the photosensitive layer and intermediate layer interact with each other, chemical resistance of the layers is improved.

A sufficient amount of heat energy is supplied to the photosensitive layer from an aluminum substrate side by heat-treating at 150 to 300°C in a burning treatment. A heat cross-link structure is presumably formed by the function of the novolac resin that is a main component of the photosensitive resin, whereby the photosensitive layer is endowed with excellent printing durability by burning.

While removal of the photosensitive layer at non-image portions may be adversely affected in the conventional infrared laser-sensitive positive photosensitive layer since a heat reaction does not advance to the vicinity of the surface of the substrate due to diffusion of the heat in the exposure process, solubility of the photosensitive layer of the present invention, in the developer, is enhanced since the specific polymer that constitutes the intermediate layer has an acidic group in the structure thereof. It is assumed that generation of stains in the non-image portion is thus effectively suppressed in the present invention.

The invention provides an infrared laser-sensitive positive image recording material that is excellent in chemical resistance and printing durability at image portions that is remarkably improved by burning. The invention also provides a planographic printing plate excellent in printing durability and chemical resistance by using the image recording material.

### DETAILED DESCRIPTION OF THE INVENTION

The image recording material of the present invention is prepared by forming, on a substrate, an intermediate layer comprising a polymer having acidic groups and capable of interacting with a novolac phenol resin contained in a photosensitive layer to be described below, and the photosensitive layer containing the novolac phenol resin and a light to heat conversion agent and being recordable with an infrared laser.

### (Intermediate layer)

The intermediate layer as a feature of the invention will be described at first.

The intermediate layer provided between the substrate and photosensitive layer comprises a polymer having an acidic group in a molecule thereof and being capable of interacting with the novolac phenol resin contained in a photosensitive layer, which photosensitive layer will be described hereinafter. The specific polymer preferably contains, in a molecule thereof, an acidic group and a functional group (which will be referred to as an "interactable functional group" hereinafter) capable of interacting with the novolac resin contained in the photosensitive layer to be described hereinafter. When the polymer having an acidic group at a side chain thereof is able to interact with the novolac resin by the function of the acidic group, the interactable functional group need not be separately introduced, and the acidic group may serve as an interactable functional group.

The polymer used in the invention is not particularly restricted so long as it involves these characteristic functional groups. The polymer may be obtained by copolymerization of a monomer having an acidic group on a side chain thereof and a monomer having an interactive functional group on a side chain thereof, by polymerization of a monomer having a functional group capable of exhibiting both of these both functions, or by introducing a given quantity of the acidic group and the interactive functional group in a side chain of the polymer. The acidic group of the invention may form an alkali metal salt or an ammonium salt.

The polymer for the intermediate layer according to the invention may be a vinyl-based polymer including an acrylic resin, a methacrylic resin or polystyrene as the main chain thereof and further including a monomer having an acidic group at a side chain thereof as a polymerization component.

While the acidic group is not particularly restricted, it preferably has a structural unit comprising at least one type of acidic group selected from the group consisting of the groups in (1) to (6) below:
(1) a phenolic hydroxyl group (-Ar-OH),
(2) a sulfonamide group (-SO₂NH-R),
(3) a substituted sulfonamide acidic group (referred to as an "active imide group" hereinafter; -SO₂NHCOR, -SO₂NHSO₂R, -CONHSO₂R),
(4) a carboxylic acid group (-CO₂H),
(5) a sulfonic acid group (-SO₃H), and
(6) a phosphoric acid group (-OPO₃H₂).

In (1) to (6), Ar represents a divalent aryl linking group that may be substituted, and R represents a hydrogen atom or a hydrocarbon group that may be substituted.

Among the polymers having the structural unit containing the acidic group selected from (1) to (6), a polymer comprising the structural unit having the carboxylic acid group (4) and other structural units is preferable in view of interaction.

Specific examples of the polymer include a polymer including as a polymerization component a monomer having the carboxylic acid group at a side chain thereof, represented by the following general formula (1) or (2): 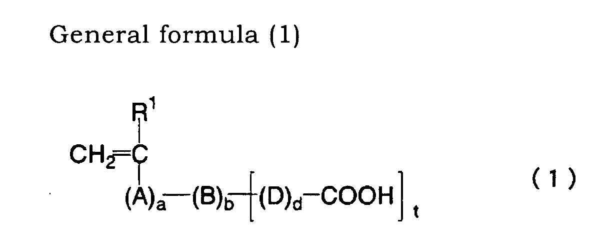 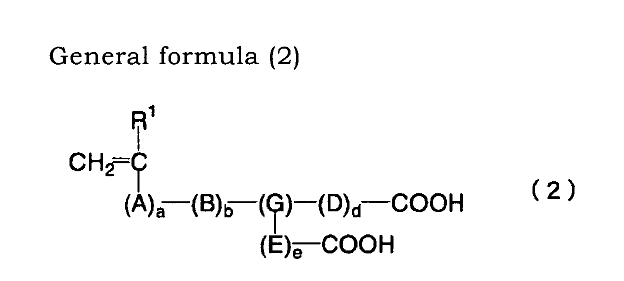 wherein A represents a divalent linking group; B represents an aromatic group or a substituted aromatic group; D and E independently represent divalent linking groups; G represents a trivalent linking group; the carboxylic acid group expressed as -COOH may form an alkali metal salt or ammonium salt; R¹ represents a hydrogen atom, an alkyl or a halogen atom; a, b, d, and e independently represent 0 or 1; and t represents an integer of 1 to 3.

Among these monomers, more preferably A is -COO- or -CONH- and B is a phenylene group or a substituted phenylene group, and examples of an introducible substituent group include a hydroxyl group, a halogen atom or an alkyl group. Preferable examples of the substituent group include a hydroxyl group or an alkyl group having 1 to 3 carbon atoms. D and E independently represent an alkylene group or a divalent linking group defined as CₙH₂ₙO, CₙH₂ₙS, or CₙH₂ₙ₊₁N, and preferably an alkylene group having 1 or 2 carbon atoms or an alkylene group having 1 or 2 carbons bonded with an oxygen atom. G represents a trivalent linking group defined by the following molecular formula CₙH₂ₙ₋₁, CₙH₂ₙ₋₁O, CₙH₂ₙ₋₁S, or CₙH₂ₙN wherein n represents an integer of 1 to 12. R¹ represents a hydrogen atom or an alkyl group. The reference characters, a, b, d, and e, independently represent 0 or 1, and a and b cannot be zero simultaneously. Preferably, a is zero and b is 1.

Specific examples of the monomers having carboxylic groups are as follows. However, the monomers of the invention are not limited to these specific examples.

### (Specific examples of monomers having carboxylic acid groups)

Examples thereof include acrylic acid, methacrylic acid, crotonic acid, isocrotonic acid, itaconic acid, maleic acid, maleic anhydride and the following monomers.

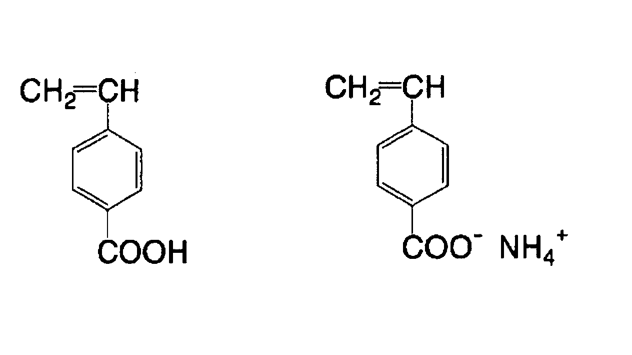

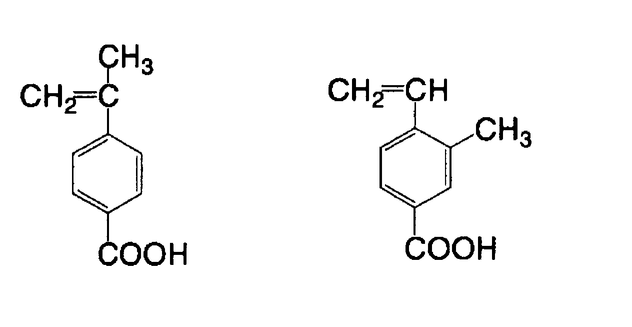

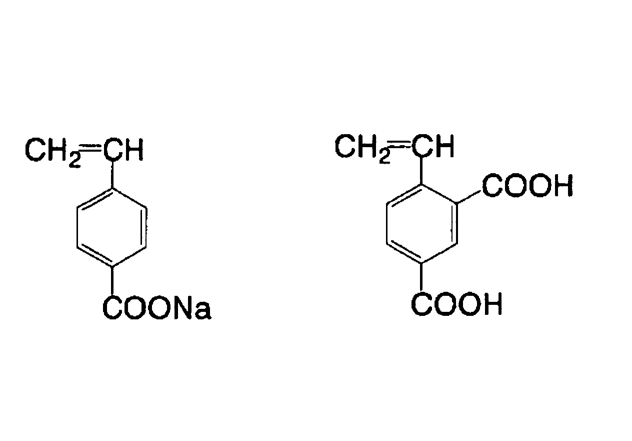

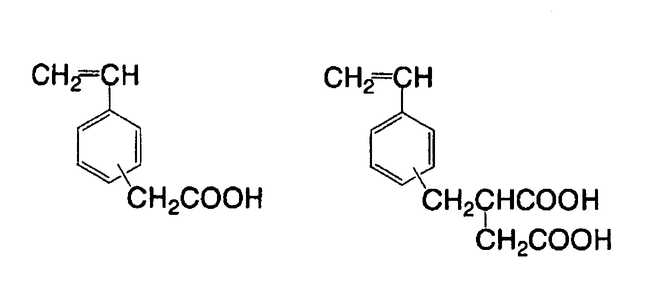

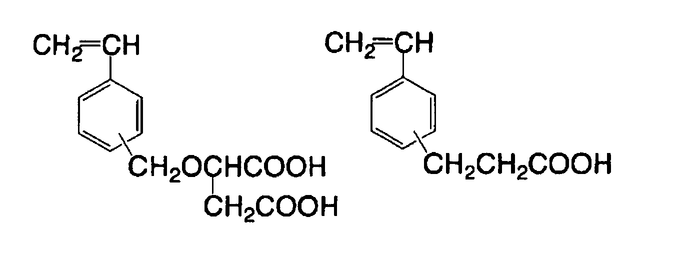

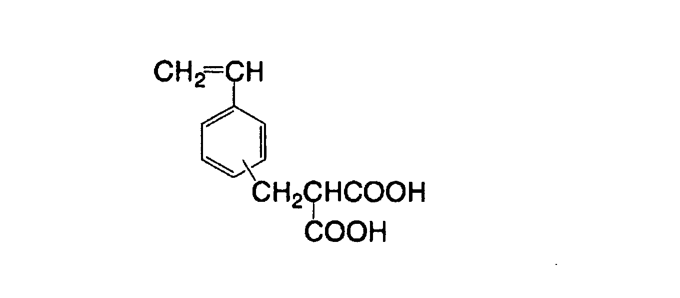

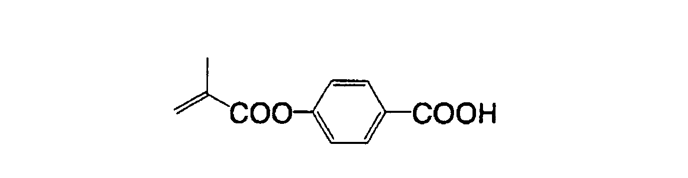

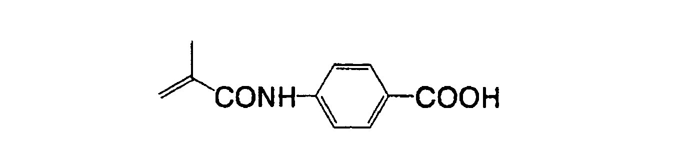

Further, other specific and preferable examples include monomers having side chain structure defined by the following general formula (I) described in Japanese Patent Application No. 2003-78699 filed by the inventors of the present invention.

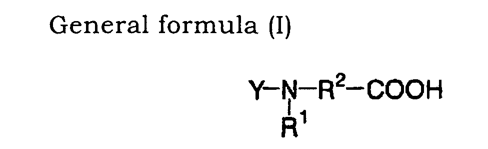

In the general formula (I), Y represents a linking group to a polymer main chain skeleton; R¹ represents a hydrogen atom or a hydrocarbon group; and R² represents a divalent hydrocarbon group.

In the general formula (I), examples of the linking group represented by Y include substituted or unsubstituted divalent hydrocarbon groups. The hydrocarbon groups may have one or more partial structures containing one or more hetero atoms selected from an oxygen atom, a nitrogen atom, and a sulfur atom.

In the general formula (I), R¹ represents a hydrogen atom or a hydrocarbon group.

As the hydrocarbon group represented by R¹, hydrocarbon groups having 1 to 30 carbon atoms are preferable. Among these hydrocarbon groups, an alkyl group or an aryl group is further preferable.

The hydrocarbon groups represented by R¹ may further have substituent groups, which will be described later. Preferable examples of the substituent group include a carboxyl group and a conjugated basic group thereof.

The most preferable form of the hydrocarbon groups represented by R¹ is alkyl or aryl group having a carboxyl group or a conjugated basic group.

The hydrocarbon groups and the substituent groups introducible into the hydrocarbon groups for R' will be described.

Specific examples of the alkyl groups represented by R' include straight chain, branched, or cyclic alkyl groups having 1 to 30 carbon atoms such as methyl, ethyl, propyl, butyl, pentyl, hexyl, heptyl, octyl, nonyl, decyl, undecyl, dodecyl, tridecyl, hexadecyl, octadecyl, eicocyl, isopropyl, isobutyl, sec-butyl, tert-butyl, isopentyl, neopentyl, 1-methylbutyl, isohexyl, 2-ethylhexyl, 2-methylhexyl, cyclopentyl, cyclohexyl, 1-adamantyl, and 2-norbonyl.

Examples of the aryl groups represented by R¹ include condensed rings formed by condensing 2 to 4 benzene rings and condensed rings of benzene rings and unsaturated five-member rings.

Specific examples of the aryl groups represented by R¹ are aryl groups having 6 to 30 carbon atoms such as phenyl, naphthyl, anthryl, phenanthryl, indenyl, acetonaphthenyl, fluorenyl, and pyrenyl.

The hydrocarbon groups represented by R¹ may be substituted with optional substituent groups at one or more sites. Examples of the substituent group introducible into R' include monovalent non-metallic atom group other than a hydrogen atom. As the substituent groups introducible into R¹, carboxyl and a conjugated basic group thereof is preferable. An alkoxycarbonyl group and an aryloxycarbonyl group are more preferable. Carboxyl and a conjugated basic group thereof are particularly preferable.

R² in the general formula (I) represents divalent hydrocarbon groups which may further comprise substituent groups. The hydrocarbon groups may contain one or more hetero atoms selected from an oxygen atom, a nitrogen atom, and a sulfur atom.

Examples of As the substituent groups introducible into R² include those exemplified as the substituent groups introducible into R¹. Examples of the preferable substituent group are also the same as those described with respect to R¹.

As the divalent hydrocarbon groups represented by R², alkylene groups which may comprise substituent groups are preferable. Specific examples of the alkylene groups include straight chain or branched chain alkylene groups such as methylene, ethylene, propylene, butylene, isopropylene, and isobutylene. Preferable examples thereof include the above-mentioned alkylene groups having carboxylic acid groups as substituents.

The carboxylic acid groups included in the general formula (I) may be in form of alkali metal salts or ammonium salts.

More preferable structure of the general formula (I) is one in which R¹ represents a carboxylic acid group-substituted hydrocarbon group and R² represents an alkylene group substituted with a straight chain alkylene or carboxylic acid group. Furthermore preferable structure of the general formula (I) is one in which R¹ represents a carboxylic acid group-substituted alkyl group and R² represents a straight chain alkylene group.

As a method for introducing the structure defined by the general formula (I) into a polymer as a side chain, monomers having the structure defined by the general formula (I) may be polymerized or copolymerized by a known method. As other methods, there are a method of causing reaction of poly-p-aminostyrene and acetic acid chloride and a method of causing reaction of polychloromethylstyrene and iminodiacetonitrile and then hydrolyzing the obtained product. In terms of easiness in control of the introduction ratio of the structure defined by the general formula (I), the method of polymerizing or copolymerizing the monomers having the structure defined by the general formula (I) by a known method is preferable.

The monomer having the structure represented by the general formula (I) preferably contains the following structure:

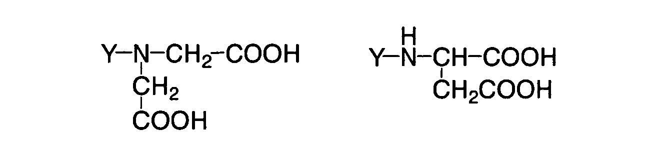

The preferable structure of the linking group which bonds the monomer to the polymer main chain skeleton represented by Y is as follows:

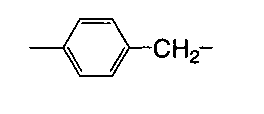

―COO―

While specific examples of the monomer having the structure represented by the general formula (I) include the following compounds, the invention is not restricted thereto:

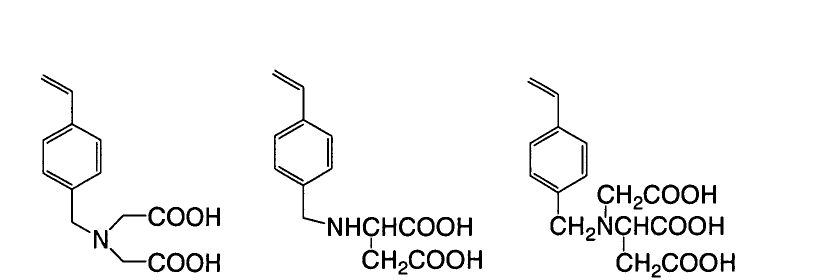

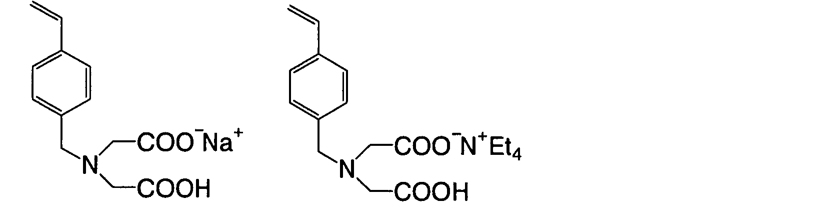

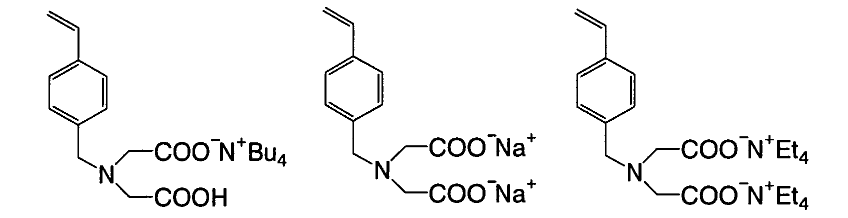

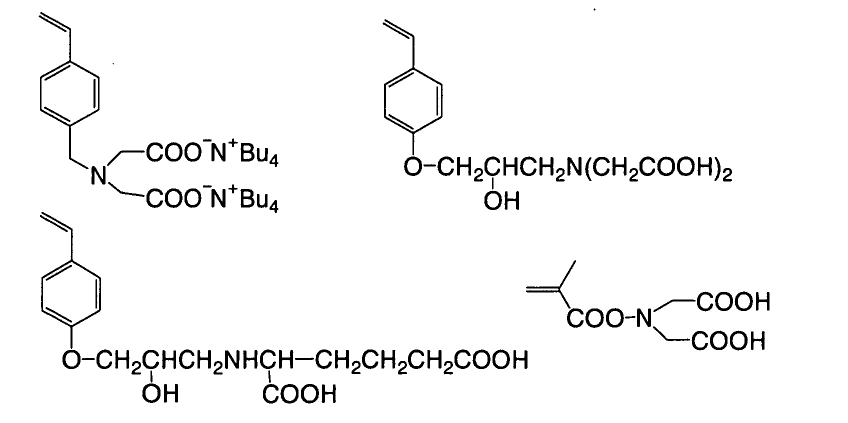

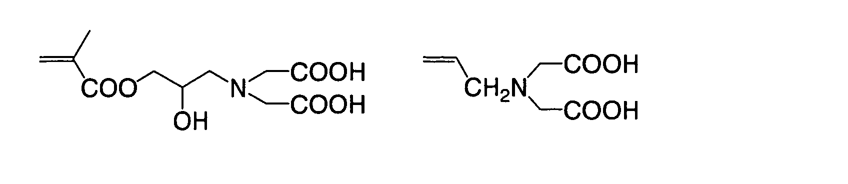

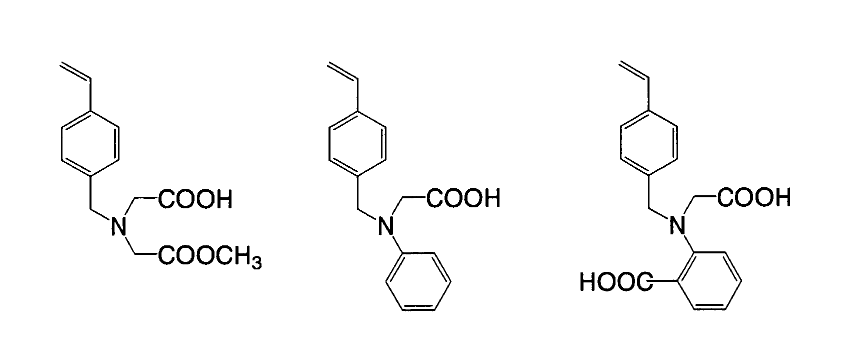

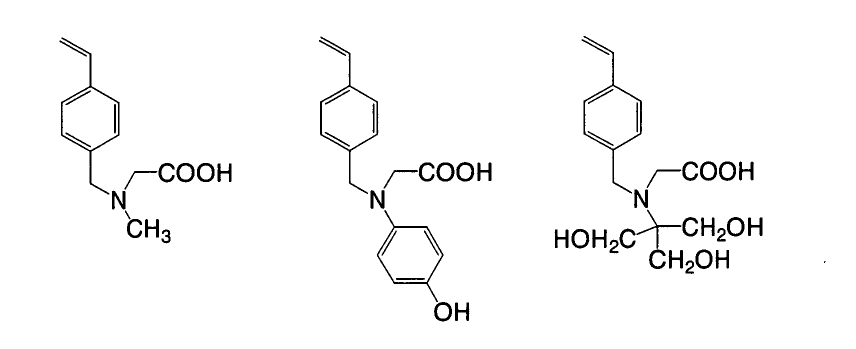

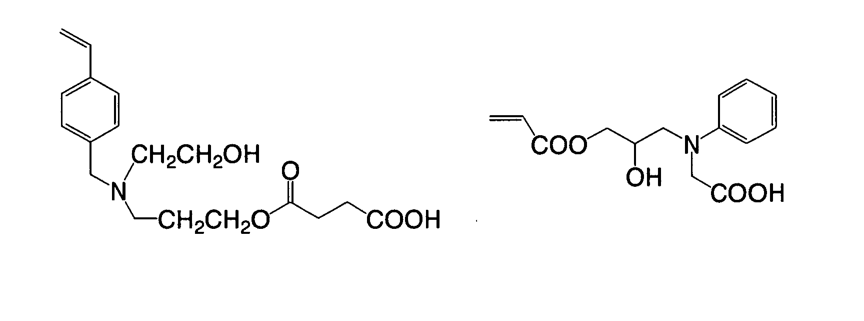

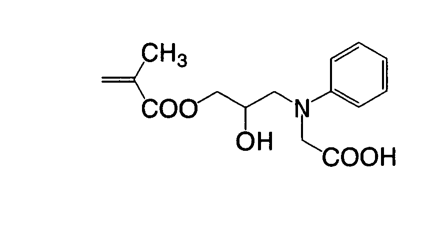

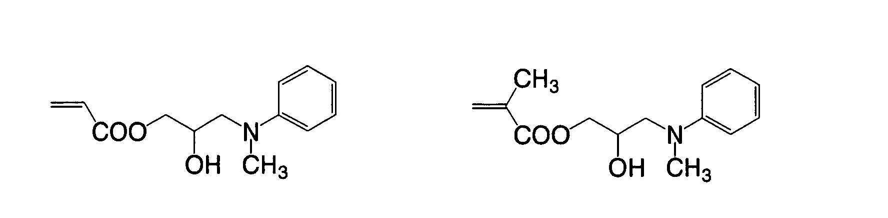

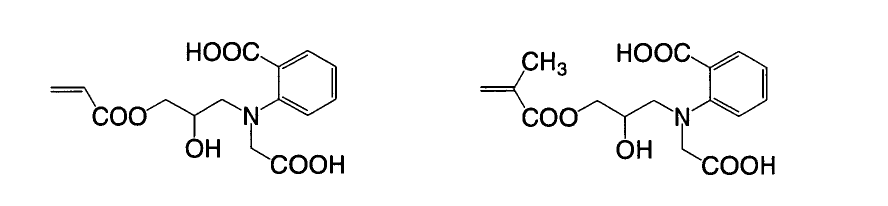

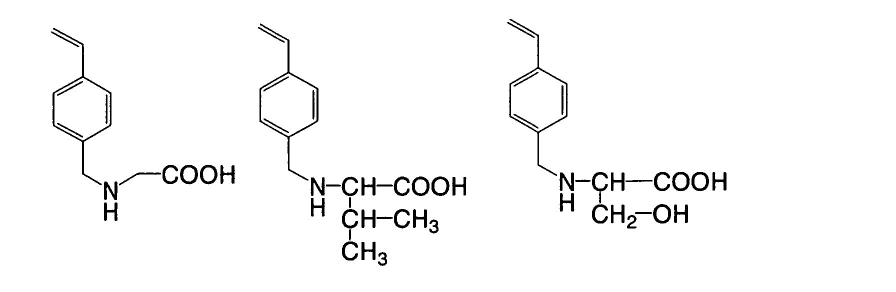

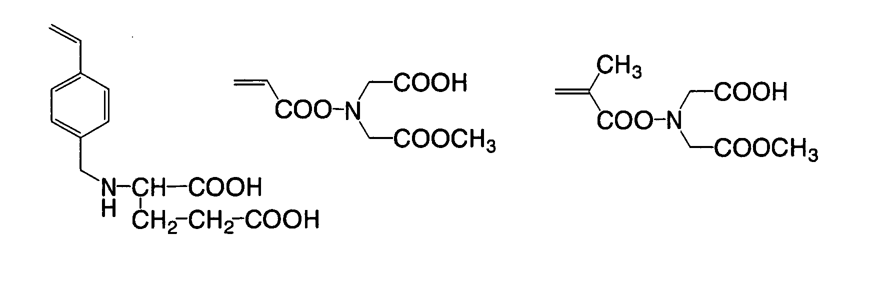

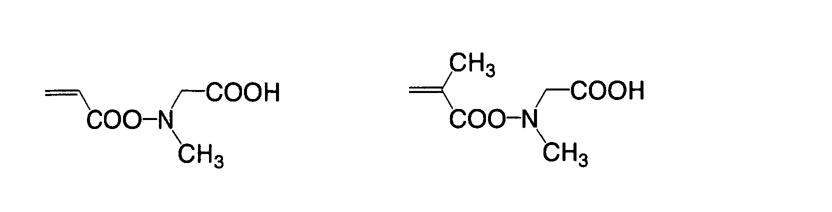

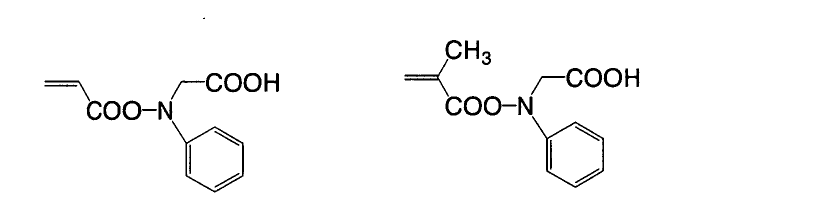

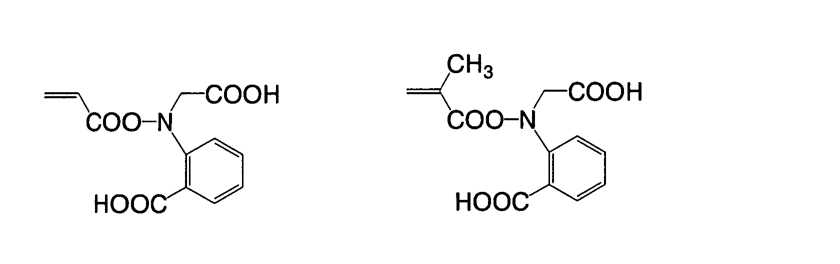

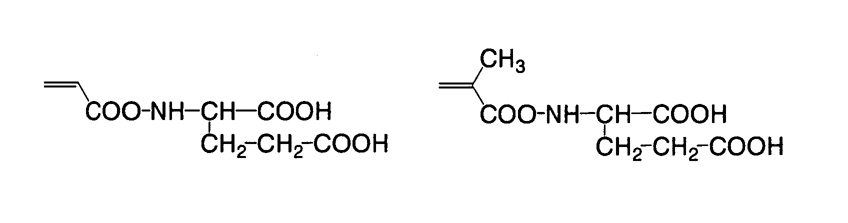

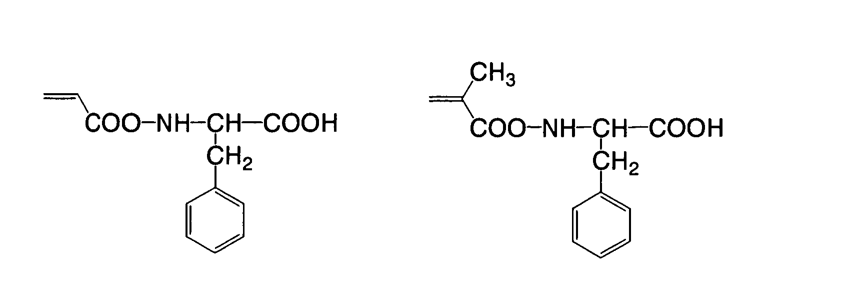

Examples of the monomer having a preferable acidic group other than those described above include the following monomers.

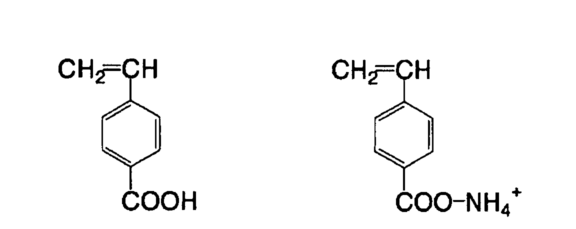

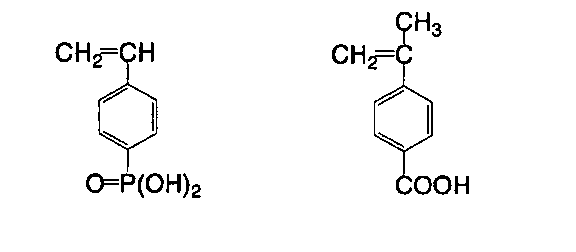

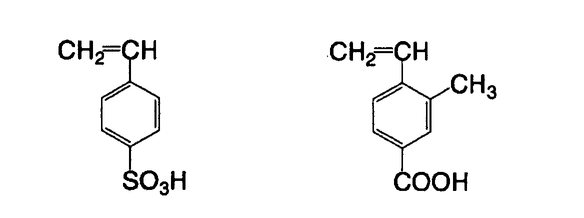

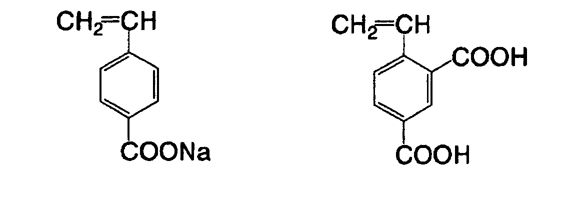

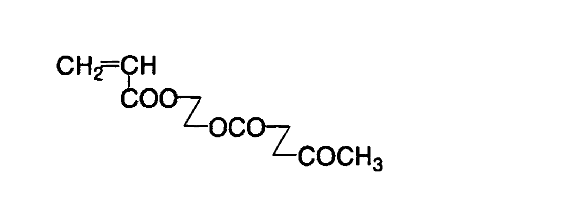

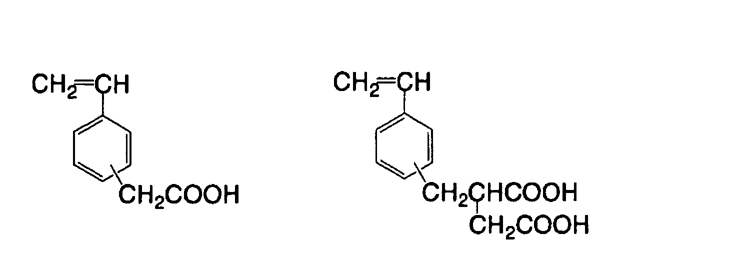

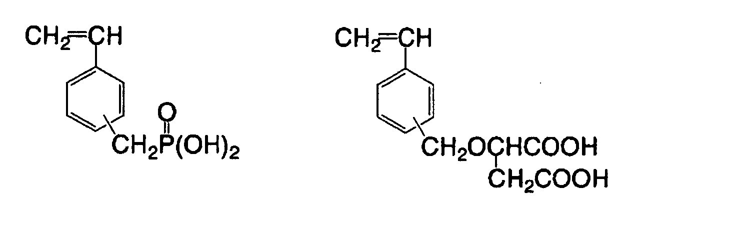

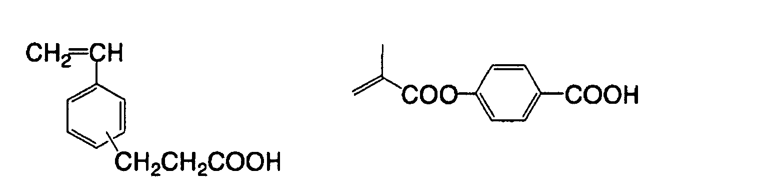

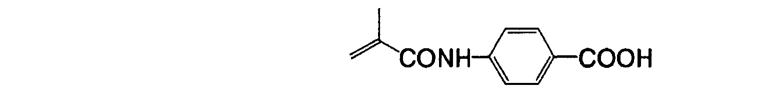

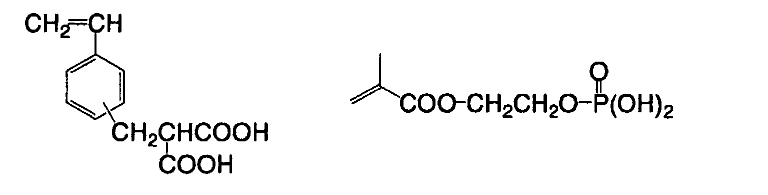

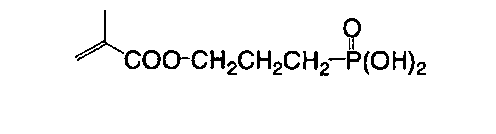

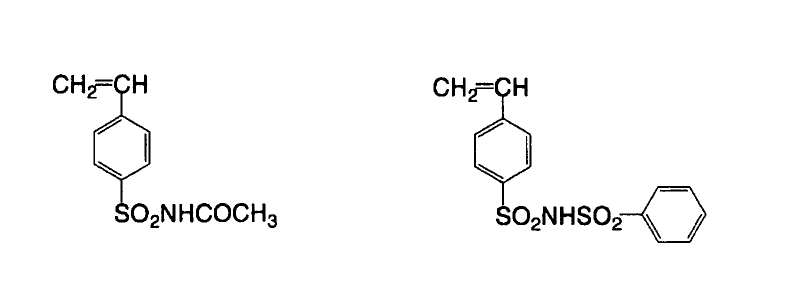

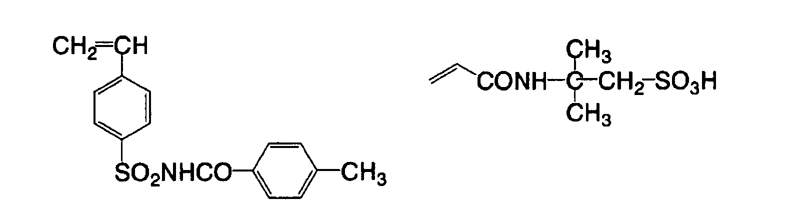

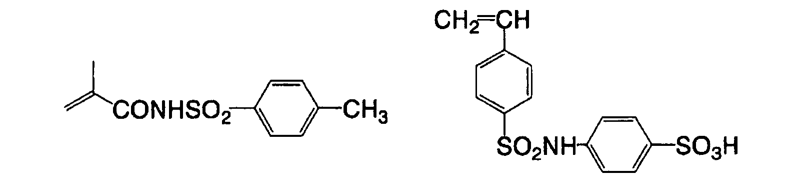

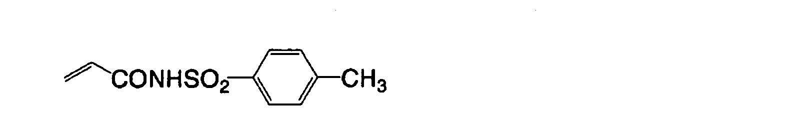

In the specific polymer according to the invention, the monomer having the carboxylic acid described above is preferable as the monomer having an acidic group in a side chain thereof in view of interaction with the novolac resin in the photosensitive layer, and a polyfunctional carboxylic acid monomer is preferable considering the strength of the interaction. The content of the monomer having the acidic group is preferably not less than 5% by mole, more preferably in the range of 20 to 100% by mole, in view of obtaining a satisfactory effect thereof.

The interactive functional groups will be described below. Examples of this functional group include a functional group capable of interacting with the phenolic hydroxyl group and alkyl group in the novolac resin through hydrogen bonds, and a functional group capable interacting with a phenyl group and an alkyl group through Van der Waals force. The preferable example also include a functional group capable of forming a complex between the polymer having the functional group and novolac resin. A representative example thereof is the carboxylic acid monomer.

While the mode of interaction between the specific polymer and phenol resin is not particularly restricted, the polymer and resin preferably forms a complex. Chemical resistance of the phenol resin is presumably improved by the interaction.

While the extent of interaction may be confirmed by the change in turbidity when the polymer that constitutes the intermediate layer and the novolac resin contained in the photosensitive layer are mixed (specifically, visually confirming of an increase in turbidity by comparing the turbidity at the mixed state with the turbidity when the polymer or resin exists alone, or of generation of visible precipitates (insoluble substances)), or by a change in viscosity (specifically, an increase in the viscosity by mixing), the method is not restricted thereto.

When the specific polymer is a copolymer, the specific polymer may be any of a random copolymer, a block polymer and a graft copolymer.

The specific polymer may be synthesized by radical polymerization using a polymerization initiator, examples thereof include a peroxide such as di-t-butyl peroxide and benzoyl peroxide, persulfate salts such as ammonium persulfate, and azo compounds such as azobisisobutylonitrile. The polymerization initiator may be appropriately selected depending on the polymerization methods used. Examples of the applicable polymerization methods include a solvent polymerization, an emulsion polymerization and a suspension polymerization.

Examples of the polymerization solvent used for the synthesis include acetone, methylethyl ketone, methanol, ethanol, propanol, ethyleneglycol monomethylether, ethyleneglycol monoethylether, diethyleneglycol dimethylether, 1-methoxy-2-propanol, 2-methoxyethyl acetate, 1-methoxy-2-propyl acetate, dimethoxyethane, methyl lactate, ethyl lactate, ethyl acetate, N,N-dimethylacetamide, N,N-dimethylformamide, dimethylsulfoxide, tetrahydrofuran, toluene and water, without being restricted thereto.

The specific polymer according to the invention preferably has a weight average molecular weight of 500 to 1,000,000, more preferably 1,000 to 500,000.

### (Other monomer components)

The specific polymer of the invention may be copolymerized with other monomer components for the purpose of strengthening the interaction with the support or the interaction with the photosensitive layer. Examples of other monomer components include "monomer containing an onium group" in terms of improving adhesion to the hydrophilized substrate and "monomer containing a lactone group" in terms of improving chemical resistance and solubility in a developer solution.

As the monomers containing an onium group, monomers defined by the following general formulas (3) to (5) can be exemplified, but they are not limited to these examples.

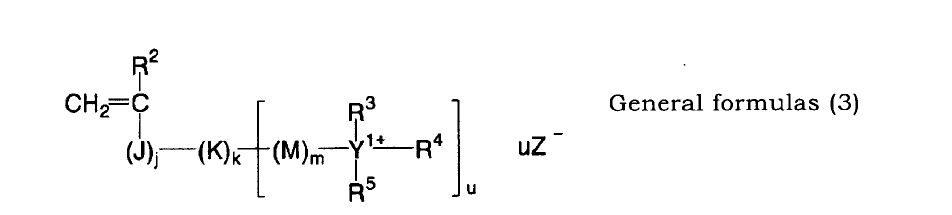

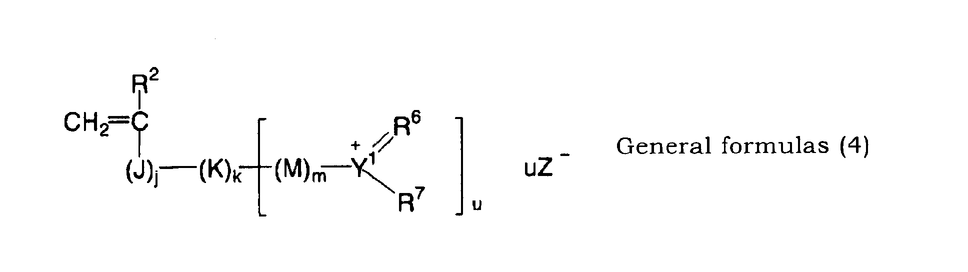

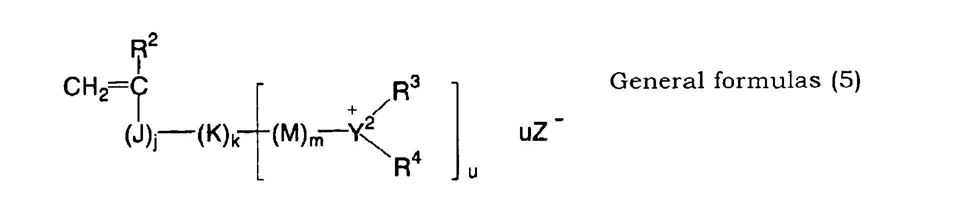

In the general formulas (3) to (5), J represents a divalent linking group; K represents an aromatic group or a substituted aromatic group; M represents a divalent linking group; Y¹ represents an atom belonging to V group in a periodic table; Y² represents an atom belonging to VI group in a periodic table; Z represents a coupled anion; R² represents a hydrogen atom, an alkyl group, or a halogen atom; R³, R⁴, R⁵, and R⁷ independently represent a hydrogen atom, or an alkyl group, an aromatic group, or an aralkyl group which may have substituent groups; R⁶ represents an alkyllysine group or a substituted alkyllysine group; R³ with R⁴ and R⁶ with R⁷ may be bonded to form rings; j, k, and m independently represent 0 or 1; and u represents an integer of 1 to 3.

Among the monomers having the onium groups defined by general formulas (3) to (5), following examples are especially preferable.

J represents -COO- or -CONH- and K represents a phenylene group or a substituted phenylene group. In the case where K represents a substituted phenylene group, the substituent group is preferably a hydroxyl group, a halogen atom, or an alkyl group.

M represents an alkylene group or a divalent linking group defined by a molecular formula CₙH₂ₙO, CₙH₂ₙS, or CₙH₂ₙ₊₁N, wherein n represents an integer of 1 to 12.

Y¹ represents a nitrogen atom or a phosphorus atom and Y² represents a sulfur atom.

Z⁻ represents a halogen ion, PF₆⁻, BF₄⁻, or R⁸SO₃⁻.

R² represents a hydrogen atom or an alkyl group.

R³, R⁴, R⁵, and R⁷ independently represent a hydrogen atom, or an alkyl group having 1 to 10 carbon atoms, an aromatic group having 6 to 10 carbon atoms, or an aralkyl group having 7 to 10 carbon atoms which may have substituent groups.

R⁶ represents an alkyllysine group or a substituted alkyllysine group having 1 to 10 carbon atoms.

R³ with R⁴ and R⁶ with R⁷ may be bonded to form rings.

The reference characters j, k, and m independently represent 0 or 1; and j and k are preferably not to be zero simultaneously.

R⁸ represents an alkyl group having 1 to 10 carbon atoms, an aromatic group having 6 to 10 atoms, or an aralkyl group having 7 to 10 atoms which may be bonded with a substituent group.

Further more preferable examples of the monomer having the onium group defined by the general formulas (3) to (5) include are follows.

K represents a phenylene group or a substituted phenylene group. In the case where K represents a substituted phenylene group, the substituent group is a hydrogen atom or an alkyl group having 1 to 3 carbon atoms.

M represents an alkylene group having 1 or 2 carbon atoms or an alkylene group having 1 or 2 carbon atoms bonded by an oxygen atom.

Z⁻ represents chlorine ion or R⁸SO₃⁻. R² represents a hydrogen atom or a methyl group. "j" is 0 and k is 1. R³ represents an alkyl group having 1 to 3 carbon atoms.

Hereinafter, specific examples of the monomer having onium group used for the specific polymer of the present invention will be exemplified, but the monomer of the invention is not limited to these examples.

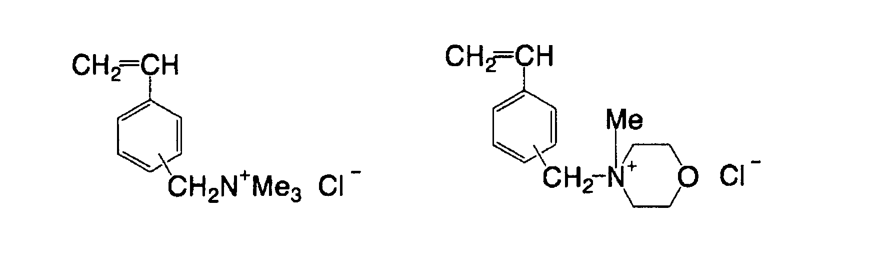

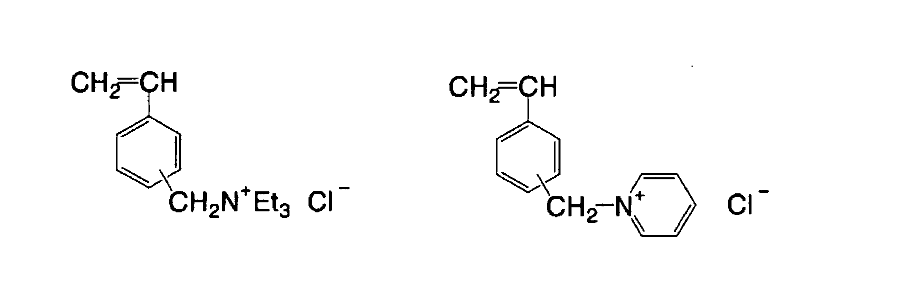

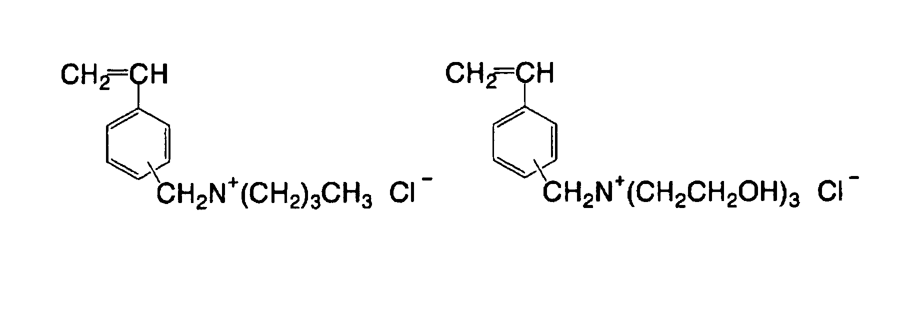

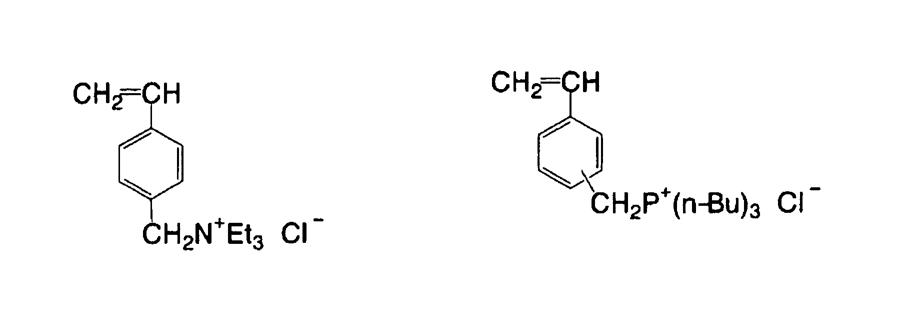

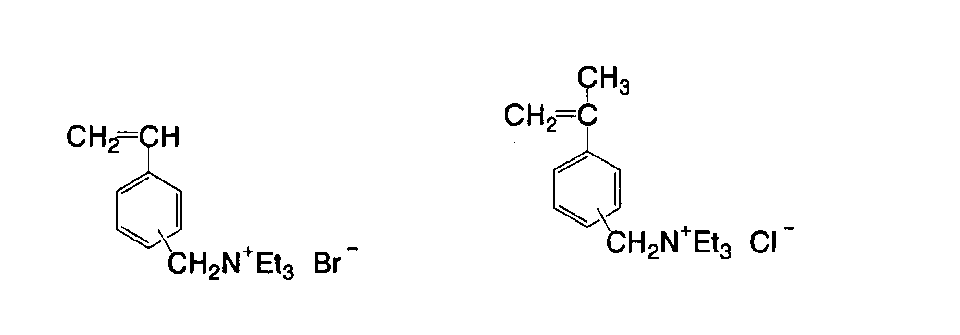

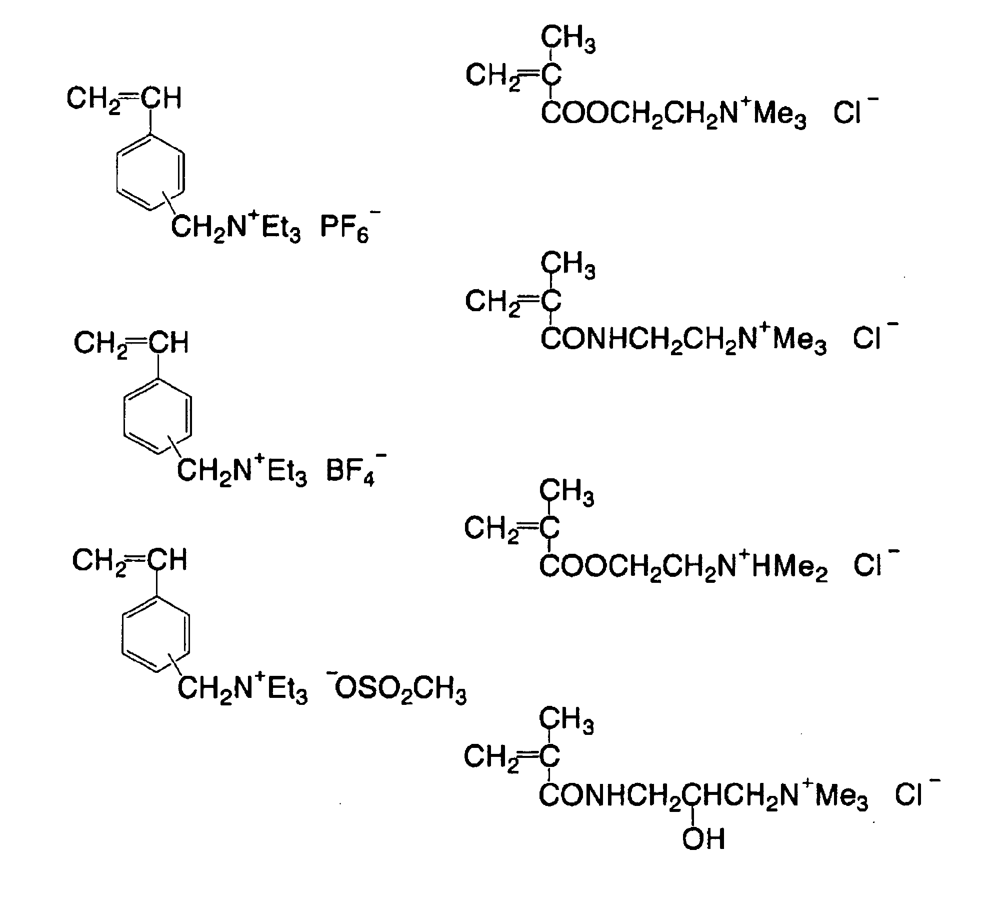

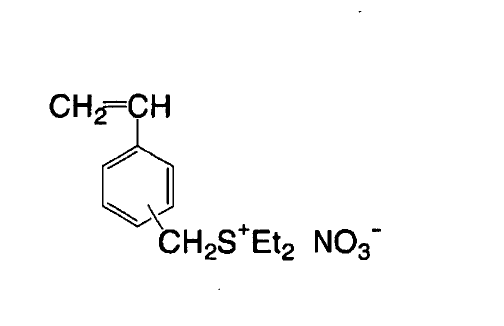

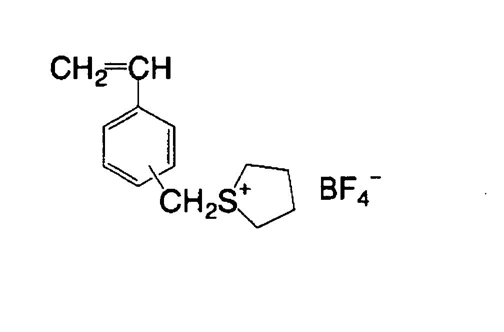

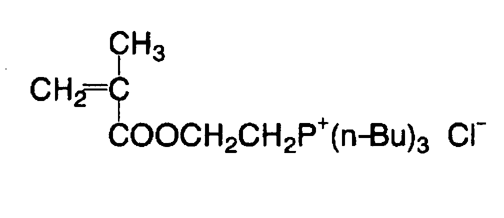

The content of the structure unit having the onium group in the specific polymer is preferably 0 to 60% by mole and more preferably 5 to 50% by mole.

Examples of the monomer having the lactone group include monomer having lactone group in the molecule thereof and an ethylene-addition polymerizable unsaturated group such as vinyl, allyl, or (meth)acryl. Examples thereof further include those having two or more lactone groups in one monomer.

Further, the lactone group and ethylenic unsaturated group are preferably bonded to each other by a single bond or a linking group and the molecular weight of such a linking group is preferably 1,000 or less.

Specific examples of the monomer having the lactone group of the present invention include pantoyl lactone (meth)acrylate, α-(meth)acryloyl-γ-butyrolactone, β-(meth)acryloyl-γ-butyrolactone or the following compounds, but the monomer of the invention is not limited to these examples (in the present specification, the term "(meth)acryl" may occasionally be used for describing at least one of acryl and methacryl).

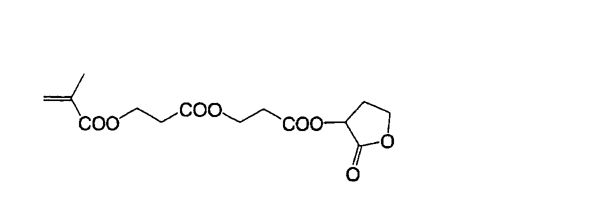

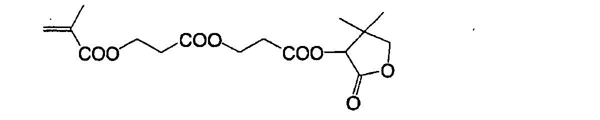

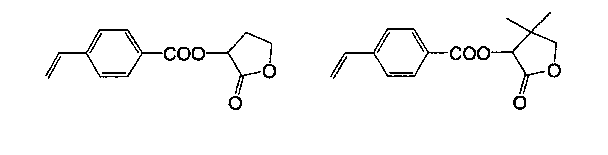

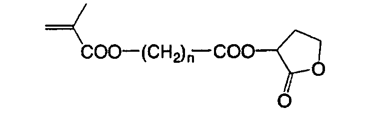

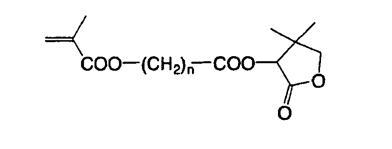

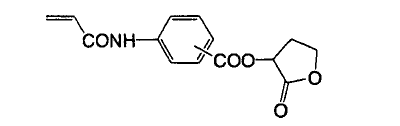

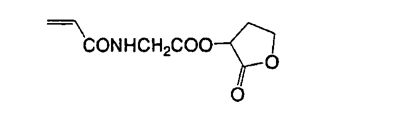

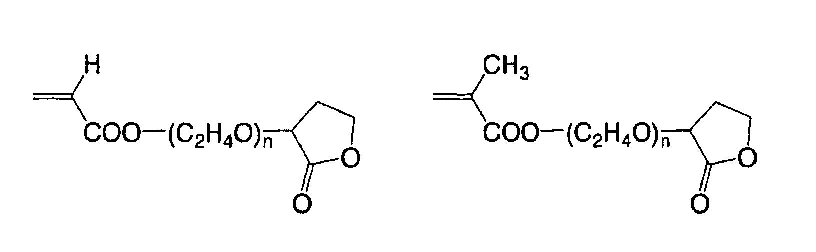

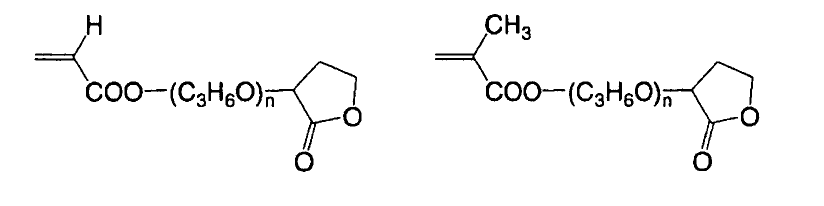

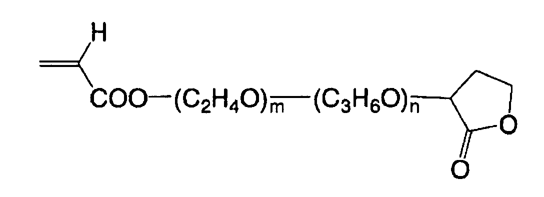

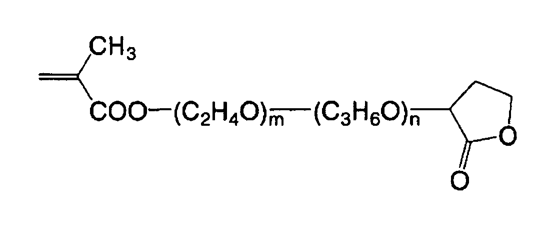

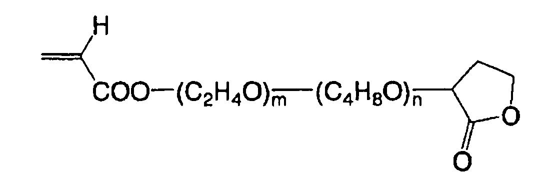

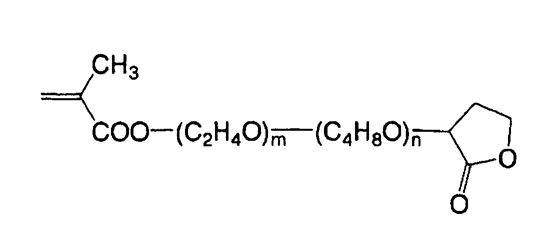

The content of the structure unit having the lactone group in the specific polymer is preferably 0 to 50% by mole and more preferably 5 to 35% by mole.

The specific monomer of the invention may comprise at least one type of monomer selected from the polymerizable monomers (1) to (7) below as a copolymerization component, in addition to the monomers and side chain structures described above:
(1) acrylamides such as N-(o-aminosulfonyl-phenyl)acrylamide, N-(m-aminosulfonylphenyl)acrylamide, N-(p-aminosulfonylphenyl)acrylamide, N-[1-(3-aminosulfonyl)naphthyl]acrylamide, and N-(2-aminosulfonylethyl)acrylamide; methacrylamides such as N-(o-aminosulfonylphenyl)methacrylamide, N-(m-aminosulfonyl-phenyl)methacrylamide, N-(p- aminosulfonylphenyl)methacrylamide, N-[1-(3-aminosulfonyl)naphthyl]methacrylamide, and N-[2-aminosulfonylethyl]methacrylamide; unsaturated sulfonamides such as acrylate esters such as o-aminosulfonylphenyl acrylate, m-aminosulfonylphenyl acrylate, p-aminosulfonylphenyl acrylate, and 1-(3-aminosulfonylphenylnaphtyl)acrylate; unsaturated sulfonamides such as methacrylate esters such as o-aminosulfonylphenyl methacrylate, m-aminosulfonylphenyl methacrylate, p-aminosulfonyl-phenyl methacrylate, 1-(3-aminosulfonylphenylnaphthyl)-methacrylate:
(2) phenylsulfonyl acrylamide that may be substituted such as tosyl acrylamide, and phenylsulfonyl methacrylamide that may be substituted such as tosyl methacrylamide:
(3) acrylamides or methacrylamides such as acrylamide, methacrylamide, N-methylol acrylamide, N-methylol methacrylamide, N-ethyl acrylamide, N-ethyl methacrylamide, N-hexyl acrylamide, N-hexyl methacrylamide, N-cyclohexyl acrylamide, N-cyclohexyl methacrylamide, N-hydroxyethyl acrylamide, N-hydroxyethyl methacrylamide, N-phenyl acrylamide, N-phenyl methacrylamide, N-benzyl acrylamide, N-benzyl methacrylamide, N-nitrophenyl acrylamide, N-nitrophenyl methacrylamide, N-ethyl-N-phenyl acrylamide and N-ethyl-N-phenyl methacrylamide:
(4) vinyl ethers such as ethylvinyl ether, 2-chloroethylvinyl ether, hydroxyethylvinyl ether, propylvinyl ether, butylvinyl ether, octylvinyl ether and phenylvinyl ether:
(5) vinyl esters such as vinyl acetate, vinyl chloroacetate, vinyl butylate an vinyl benzoate:
(6) olefins such as ethylene, propylene, isobutylene, butadiene and isoprene: and
(7) N-vinyl carbazole, 4-vinylpyridine, acrylonitrile and methacrylonitrile.

Specific examples of the preferable monomer that may be used together include following functional groups (a)-(e) capable of interacting with the component of the photosensitive layer through hydrogen bonds:
(a) acrylamides, methacrylamides, acrylate esters, methacrylate esters and hydroxystyrenes having an aromatic hydroxyl group such as N-(4-hydroxyphenyl)acrylamide or N-(4-hydroxyphenyl)methacrylamide, o-, m- or p-hydroxystyrene, o- or m-bromo-p-hydroxystyrene, o- or m-chloro-p-hydroxystyrene, and o-, m- or p-hydroxyphenyl acrylate or methacrylate;
(b) unsaturated carboxylic acids such as acrylic acid, methacrylic acid, maleic acid and maleic anhydride, and half esters thereof; and itaconic acid and itaconic anhydride, and half esters thereof:
(c) acrylate esters and methacrylate esters having an aliphatic hydroxyl group such as 2-hydroxyethyl acrylate or 2-hydroxyethyl methacrylate:
(d) N-vinyl pyrrolidone: and
(e) ethylene oxide group-containing monomers such as polyethyleneglycol mono(meth)acrylate, polypropylene-glycol mono(meth)acrylate, and methoxypolyethyleneglycol (meth)acrylate.
(f) the monomers having a functional group capable of interacting with the component in the photosensitive layer by Van der Waals force, examples thereof include (substituted) acrylate esters such as methyl acrylate, ethyl acrylate, propyl acrylate, butyl acrylate, amyl acrylate, hexyl acrylate, cyclohexyl acrylate, octyl acrylate, phenyl acrylate, benzyl acrylate, 2-chloroethyl acrylate, 4-hydroxybutyl acrylate, glycidyl acrylate and N-dimethylaminoethyl acrylate:
(g) (substituted) methacrylate esters such as methyl methacrylate, ethyl methacrylate, propyl methacrylate, butyl methacrylate, amyl methacrylate, hexyl methacrylate, cyclohexyl methacrylate, octyl methacrylate, phenyl methacrylate, benzyl methacrylate, 2-chloroethyl methacrylate, 4-hydroxybutyl methacrylate, glycidyl methacrylate and N-dimethylaminoethyl methacrylate:
(h) styrenes such as styrene, α-methyl styrene, methyl styrene and chloromethyl styrene:
(i) vinyl ketones such as methylvinyl ketone, ethylvinyl ketone, propylvinyl ketone and phenylvinyl ketone: and
(j) lactone-containing monomers such as pantoyl lactone (meth)acrylate, α-(meth)acryloyl-γ-butyrolactone and β-(meth)acryloyl-γ-butyrolactone.

While specific examples of the polymer (P-1 to P-15) according to the invention are listed below, the invention is not restricted thereto.

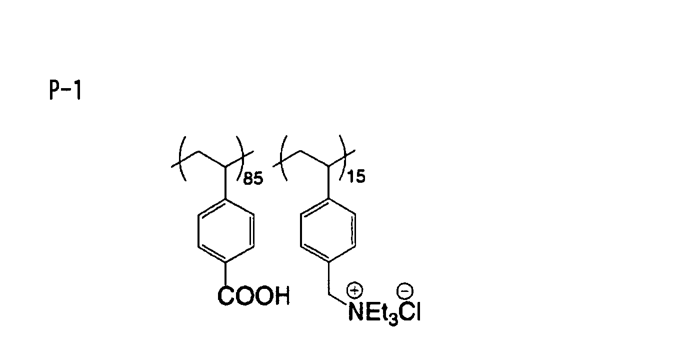

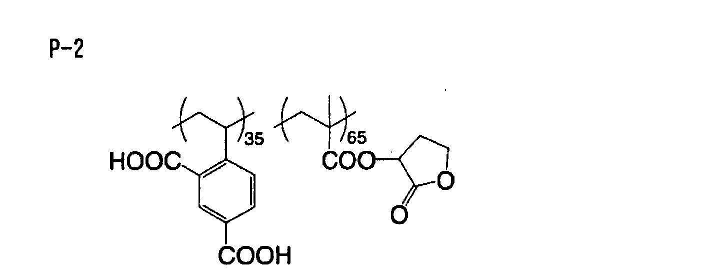

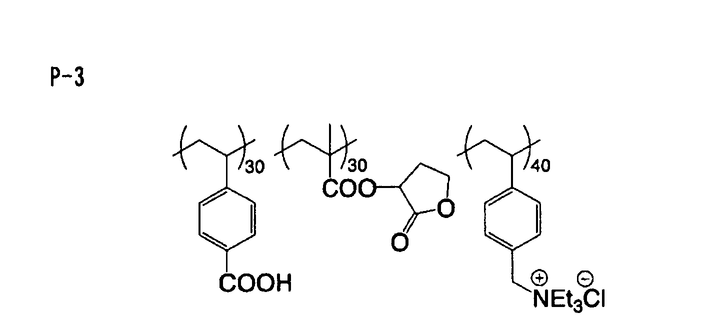

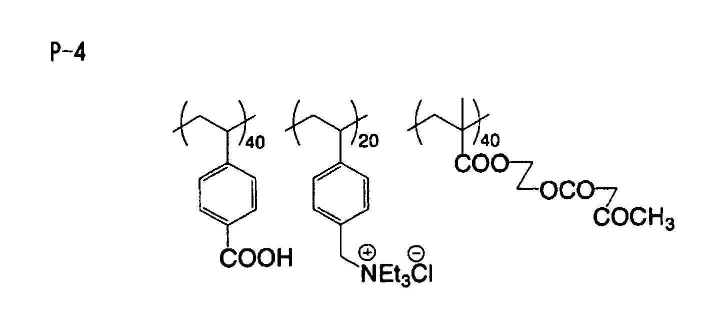

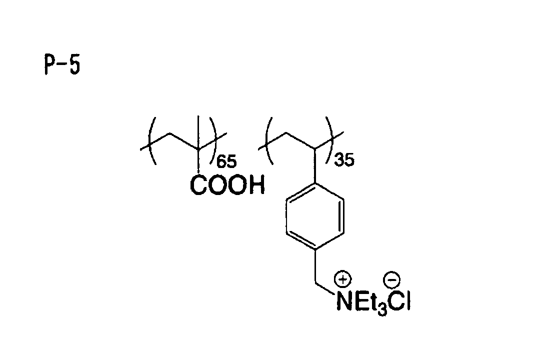

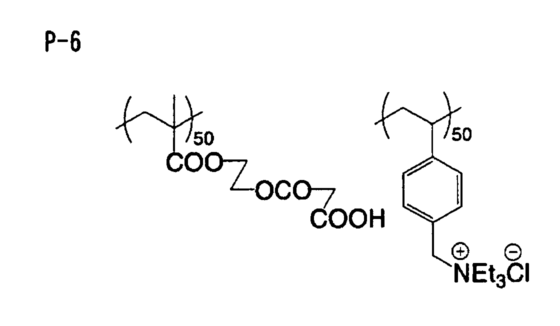

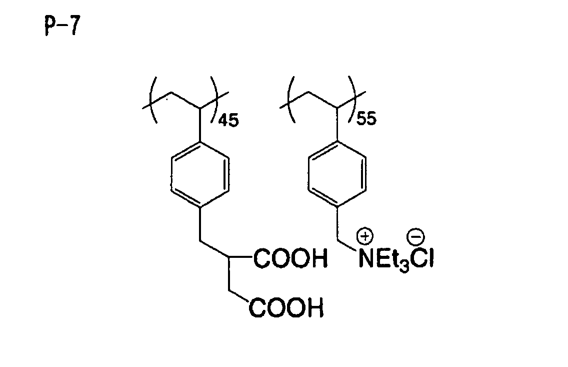

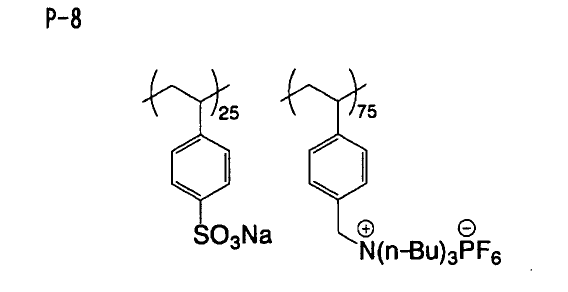

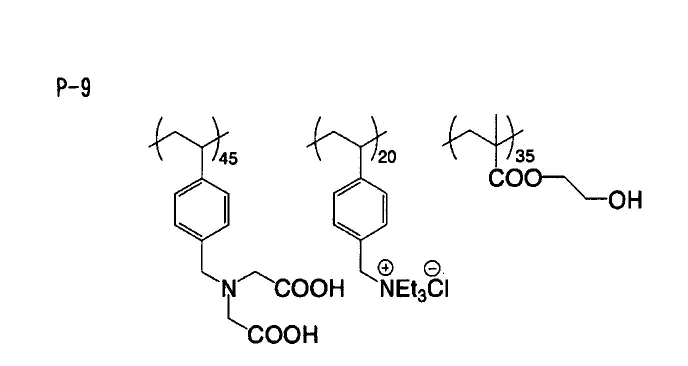

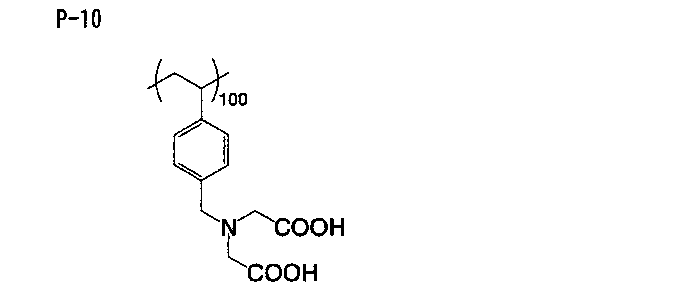

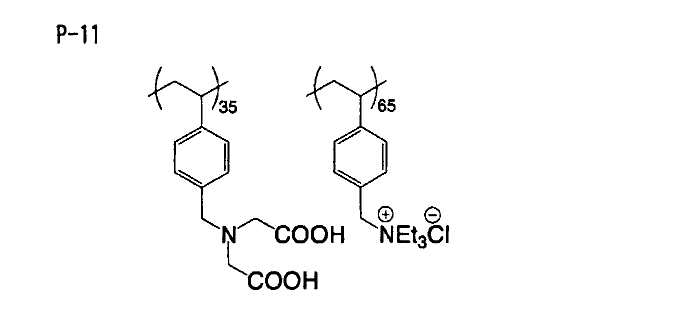

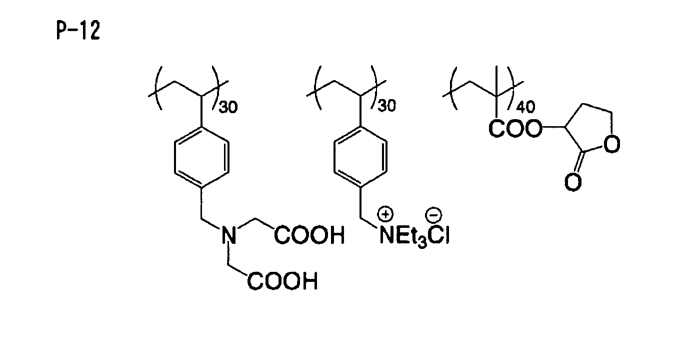

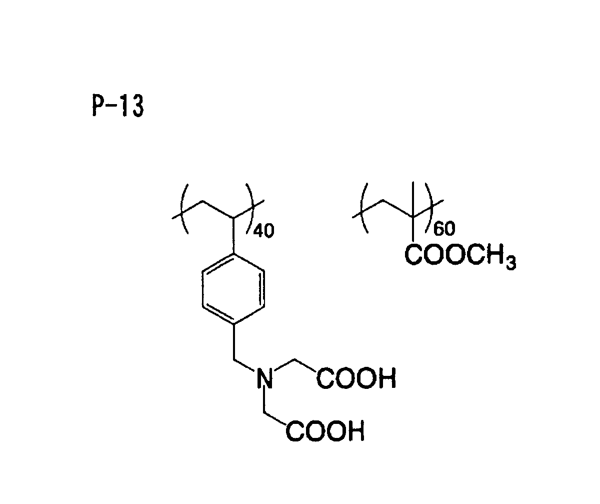

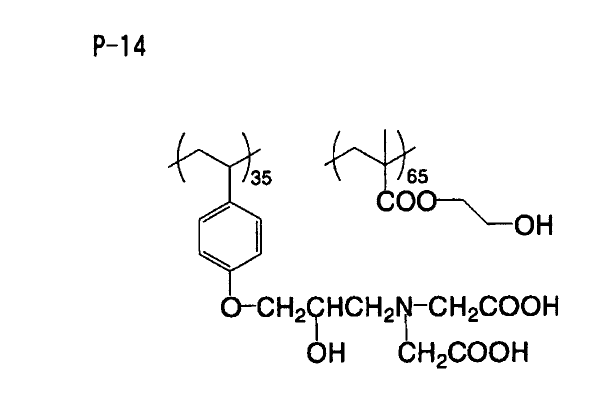

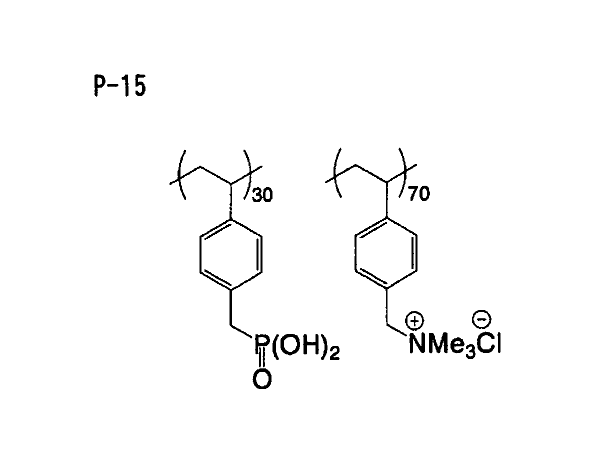

The content of the specific polymer in the intermediate layer on the basis of total solid matter composing the intermediate layer is preferably 30 to 100% by weight and 50 to 100% by weight.

### (Formation of the intermediate layer)

The intermediate layer of the invention can be formed by applying a coating solution (a coating solution for intermediate layer formation) containing the above-mentioned respective components of the intermediate layer to a support, which will be described later, by a variety of methods. The method for coating the intermediate layer is not particularly limited and typical methods can be exemplified as follows.

That is, (1) a coating method involving applying a solution obtained by dissolving the specific polymer of the invention in an organic solvent such as methanol, ethanol, and methyl ethyl ketone, a mixture thereof, or a mixture of these organic solvents and water, to a support, and drying the solution. Or, (2) a coating method involving immersing a support in a solution obtained by dissolving the specific polymer of the invention in an organic solvent such as methanol, ethanol, and methyl ethyl ketone, a mixture thereof, or a mixture of these organic solvents and water and drying the solution, washing the support with water or air, and drying again the support, to form the intermediate layer.

In the case of the coating method (1), the solution with a concentration of 0.005 to 10% by weight in the total of the above-mentioned compounds may be applied by a variety of methods. The coating means may be any means including, for example, a bar coater coating, a rotation coating, a spray coating, and a curtain coating. In the case of the coating method (2), the concentration of the solution is 0.005 to 20% by weight, preferably 0.01 to 10% by weight, and the immersion temperature is 0 to 70°C, preferably 5 to 60°C, and the immersion period is 0.1 to 5 minutes, preferably 0.5 to 120 seconds.

The coating solution for the intermediate layer formation may be used at a controlled pH to be in a pH range of 0 to 12, preferably 0 to 6 by using basic substances such as ammonia, triethylamine, and potassium hydroxide; inorganic acids such as hydrochloric acid, phosphoric acid, sulfuric acid and nitric acid; organic sulfonic acids such as nitrobenzenesulfonic acid and naphthalenesulfonic acid; organic phosphonic acids such as phenylphosphonic acid; various acidic substances such as organic carboxylic acid including benzoic acid, cumaric acid, and malic acid; and organic chlorides naphthalene sulfonyl chloride and benzene sulfonyl chloride.

Further, to the coating solution for the intermediate layer formation, for improving the condition reproducibility of the planographic printing plate, substances absorbing UV rays, visible rays, and IR rays may be added.

The coating amount of the intermediate layer of the invention after drying is to be 1 to 100 mg/m² and preferably 2 to 70 mg/m² in total.

### [Photosensitive layer]

On the above-mentioned intermediate layer, a photosensitive layer, containing 50% by weight or more of novolak type phenol resin (hereinafter, sometimes referred to as novolak resin) and a photothermal conversion agent and recordable by IR laser beam, is formed.

At first, novolak type phenol resin will be described. The novolak resin is a resin obtained by condensation-polymerizing at least one kind of phenol resins with aldehydes or ketones in the presence of an acidic catalyst.

Here, examples of the phenols include phenol, o-cresol, m-cresol, p-cresol, 2,5-xylenol, 3,5-xylenol, o-ethylphenol, methylphenol, p-ethylphenol, propylphenol, n-butylphenol, tertbutylphenol, 1-naphthol, 2-naphthol, pyrocatechol, resorcinol, hydroquinone, pyrogallol, 1,2,4-benzenetriol, fluoroglucinol, 4,4'-biphenyldiol, and 2,2'-bis(4'-hydroxyphenyl)propane, examples of the aldehydes include formaldehyde, acetaldehyde, propionaldehyde, benzaldehyde, and furfural, and examples of the ketones include acetone, methyl ethyl ketone and methyl isobutyl ketone.

Preferable condensed polymers are those obtained from phenols selected from phenol, o-cresol, m-cresol, p-cresol, 2,5-xylenol, 3,5-xylenol, and resorcinol and either aldehydes selected from formaldehyde, acetaldehyde, and propionaldehyde or ketones. Particularly preferable condensed polymers are those obtained from mixed phenols in which mixing ratios of m-cresol:p-cresol:2,5-xylenol:3,5-xylenol:resorcinol by mole = (40 to 100):(0 to 50):( 0 to 20):( 0 to 20):( 0 to 20) or mixed phenols in which mixing ratios of phenol:m-cresol:p-cresol by mole = (0 to 100):(0 to 70):(0 to 60) and formaldehyde.

These novolak resins to be employed have a weight average molecular weight on the basis of polystyrene conversion by gel permeation chromatography (hereinafter, simply referred to as "weight average molecular weight") preferably in a range of 500 to 20,000, further preferably in a range of 1,000 to 15,000, and further more preferably 3,000 to 12,000. If the weight average molecular weight is in the aforementioned range, sufficient film formability and excellent alkali developability of exposed portions can be obtained and therefore it is preferable.

Only one type of the novolac resin may be used, or plural kinds of the novolac resin may be used together, for the binder resin in the photosensitive layer. The content of the novolac resin is preferably in a range of 50 to 99% by mass, more preferably in a range of 60 to 95% by mass, with respect to the total solid content of the photosensitive layer.

All the binder resins may comprise the novolac resin, or other resins may be used together. The novolac resin is preferably the main binder when other resins are used together, and the proportion of the novolac resin in the resin component constituting the photosensitive layer is preferably not less than 50% by mass.

As the binder resins usable in combination, examples thereof include commonly used alkali-soluble resins which are water-insoluble and alkali-soluble and have acidic groups in at least one of the main chain and side chains of the polymer. Preferable examples to be used as the phenol resins other than the novolak resin include resol resin, polyvinyl phenol resin, and phenolic hydroxyl-containing acrylic resin. Examples of resin usable in combination include polymers described in the specifications of, for example, JP-A No. 11-44956, Japanese Patent Application No. 2001-368587 filed by the applicants of the present invention, and Japanese Patent Application No. 2002-81044.

The photosensitive layer of the invention may contain a photothermal conversion agent. As the photothermal conversion agent to be use here, any substances can be used without limit in the absorption wavelength region as long as they can absorb the photo-energy radiation beam and generate heat. In terms of availability and applicability to the high output power laser, preferable examples thereof include IR-absorptive dyes or pigments having the maximum absorption at wavelength of 760 nm to 1,200 nm.

The dyes may be commercially available ones and known ones described in publications such as "Dye Handbook" (edited by the Society of Synthesis Organic Chemistry, Japan, and published in 1970). Specific examples thereof include azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squalirium dyes, pyrylium dyes, metal thiolate complexes, oxonol dyes, diimonium dyes, aminium dyes, and croconium dyes.

Preferable examples of the dye include cyanine dyes described in JP-A Nos. 58-125246, 59-84356, 59-202829, and 60-78787; methine dyes described in JP-A Nos. 58-173696, 58-181690, and 58-194595; naphthoquinone dyes described in JP-A Nos. 58-112793, 58-224793, 59-48187, 59-73996, 60-52940, and 60-63744; squalirium dyes described in JP-A No. 58-112792; and cyanine dyes described in GB Patent No. 434,875.

Other preferable examples of the dye include near infrared absorbing sensitizers described in U.S. Patent No. 5,156,938; substituted arylbenzo(thio)pyrylium salts described in U.S. Patent No. 3,881,924; trimethinethiapyrylium salts described in JP-A No. 57-142645 (U.S. Patent No. 4,327,169); pyrylium type compounds described in JP-A Nos. 58-181051, 58-220143, 59-41363, 59-84248, 59-84249, 59-146063, and 59-146061; cyanine dyes described in JP-A No. 59-216146; pentamethinethiopyrylium salts described in U.S. Patent No. 4,283,475; and pyrylium compounds described in Japanese Patent Application Publication (JP-B) Nos. 5-13514 and 5-19702.

Additional preferable examples of the dye include near infrared absorbing dyes represented by formulae (I) and (II) as described in U.S. Patent No. 4,756,993.

Among these dyes, particularly preferable are cyanine dyes, phthalocyanine dyes, oxonol dyes, squalirium dyes, pyrylium salts, thiopyrylium dyes, and nickel thiolate complexes. Dyes represented by the following general formulae (a) to (e) are also preferable since such dyes are excellent in terms of photothermal conversion efficiency. The cyanine dyes represented by the following general formula (a) are most preferable for the following reason: when the dyes are used in the photosensitive composition of the invention, the dyes manifest a high degree of interaction with the alkali-soluble resin, and the dyes are also excellent in terms of stability and economy.

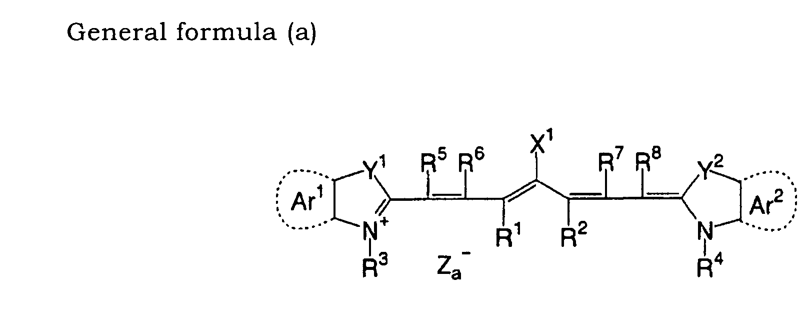

In general formula (a), X¹ represents a hydrogen atom, a halogen atom, -NPh₂, X²-L¹ (wherein X² represents an oxygen atom or a sulfur atom, L¹ represents a hydrocarbon group having 1 to 12 carbon atoms, an aromatic cyclic group having a heteroatom, or a hydrocarbon group containing a heteroatom and having 1 to 12 carbon atoms, and the heteroatom referred to herein is N, S, O, a halogen atom, or Se), or a group represented by the following: 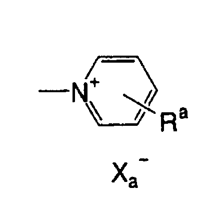 wherein Xa⁻ has the same definition as Za⁻, which will be described at a later time, and R^{a} represents a substituent selected from a hydrogen atom, an alkyl group, an aryl group, a substituted or unsubstituted amino group, or a halogen atom;

R¹ and R² each independently represents a hydrocarbon group having 1 to 12 carbon atoms, and from the viewpoint of the storage stability of the photosensitive composition of the invention when it is used in a coating solution for forming a recording layer of a planographic printing plate precursor, it is preferable that R¹ and R² each independently represents a hydrocarbon group having 2 or more carbon atoms, and more preferably R¹ and R² are bonded to each other to form a 5-membered or 6-membered ring.

Ar¹ and Ar², which may be the same or different, each represent an aromatic hydrocarbon group which may have a substituent. Preferable examples of the aromatic hydrocarbon group include benzene and naphthalene rings. Preferable examples of the substituent include hydrocarbon groups having 12 or less carbon atoms, halogen atoms, and alkoxy groups having 12 or less carbon atoms.

Y¹ and Y², which may be the same or different, each represents a sulfur atom, or a dialkylmethylene group having 12 or less carbon atoms.

R³ and R⁴, which may be the same or different, each represents a hydrocarbon group which has 20 or less carbon atoms and may have a substituent. Preferable examples of the substituent include alkoxy groups having 12 or less carbon atoms, a carboxyl group, and a sulfo group. R⁵, R⁶, R⁷ and R⁸, which may be the same or different, each represents a hydrogen atom, or a hydrocarbon group having 12 or less carbon atoms, and since the raw materials thereof can easily be obtained, each preferably represents a hydrogen atom.

Za⁻ represents a counter anion. However, in a case where the cyanine dye represented by general formula (a) has an anionic substituent in the structure thereof and there is accordingly no need to neutralize electric charges in the dye, Za⁻ is not required. From the viewpoint of the storage stability of the recording layer coating solution, Za⁻ is preferably an ion of a halogen, perchlorate, tetrafluroborate, hexafluorophosphate, carboxylate or sulfonate. From the viewpoints of compatibility of the dye with the alkali-soluble resin and solubility in the coating solution, Za⁻ is preferably a halogen ion, or an organic acid ion such as a carboxylic acid ion or sulfonic acid ion, more preferably a sulfonic acid ion, and even more preferably an arylsulfonic acid ion.

Specific examples of the cyanine dye represented by general formula (a), and which can be preferably used in the invention, include dyes in JP-A No. 2001-133969 (paragraphs [0017] to [0019]), JP-A No. 2002-40638 (paragraphs [0012] to [0038]), and JP-A No. 2002-23360 (paragraphs [0012] to [0023]), as well as dyes illustrated below.

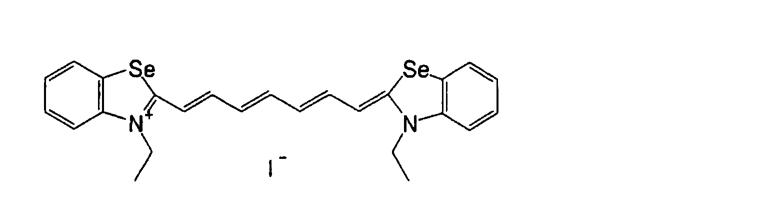

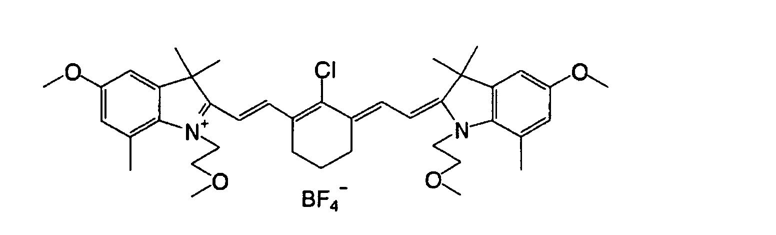

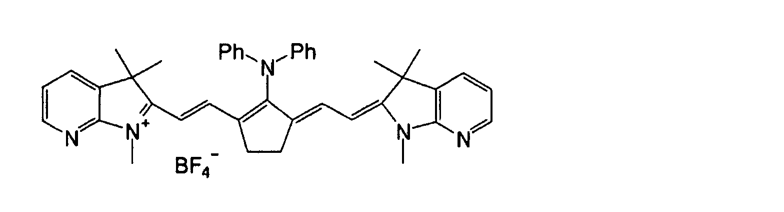

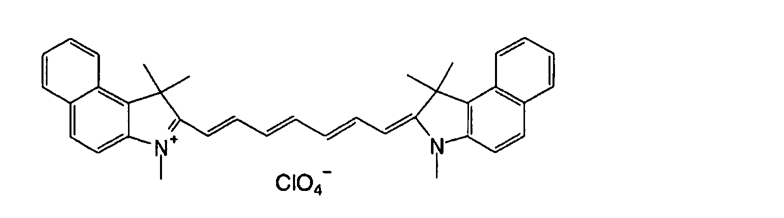

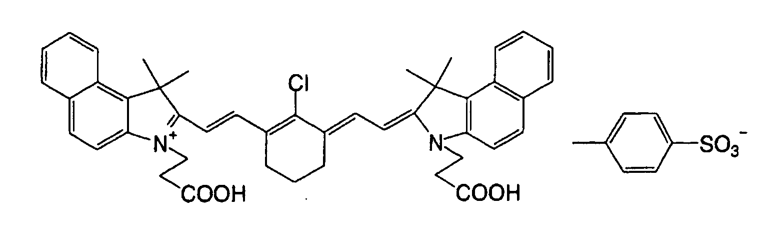

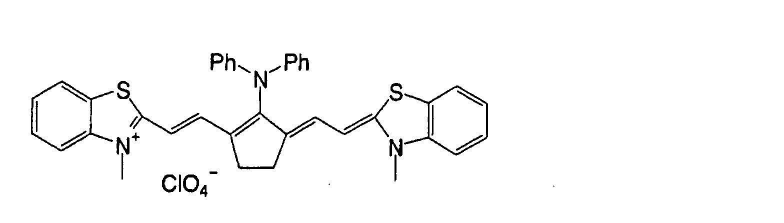

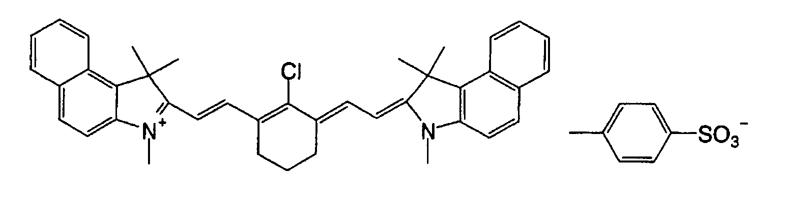

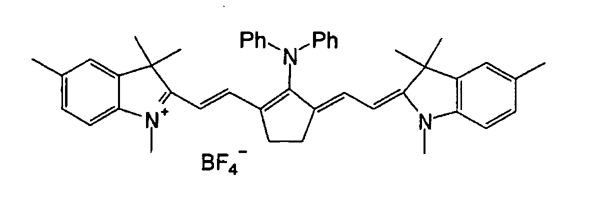

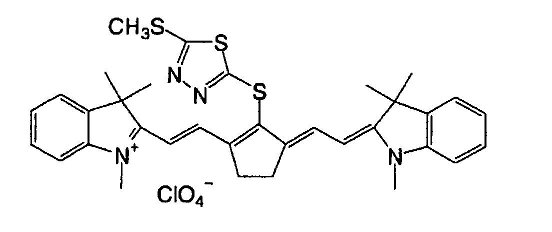

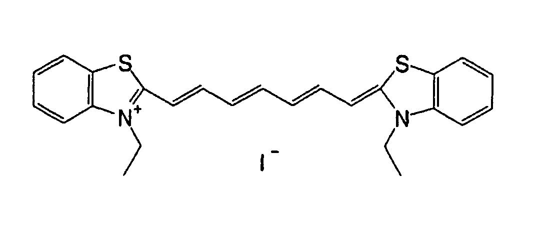

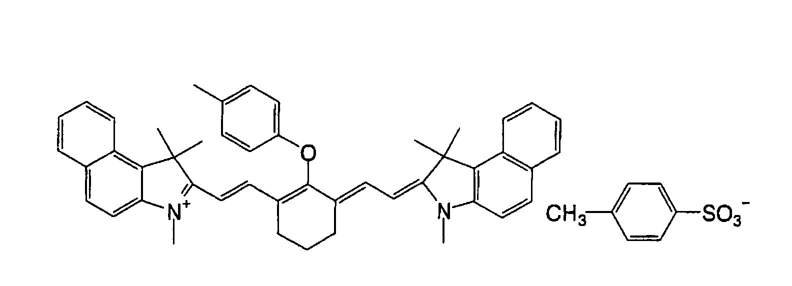

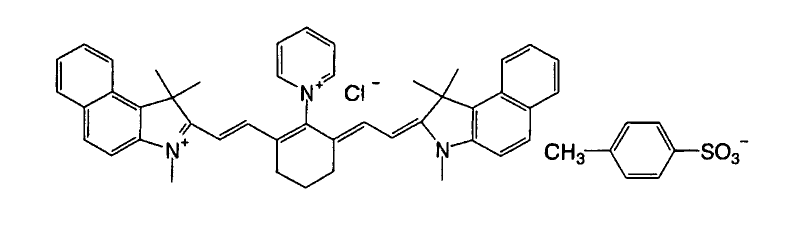

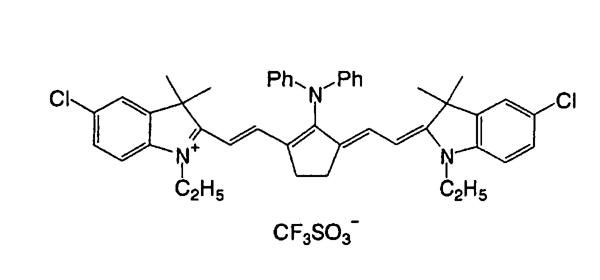

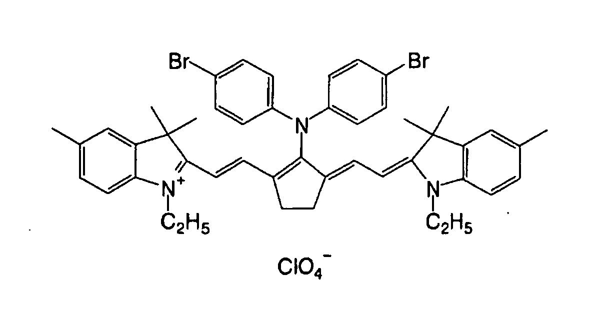

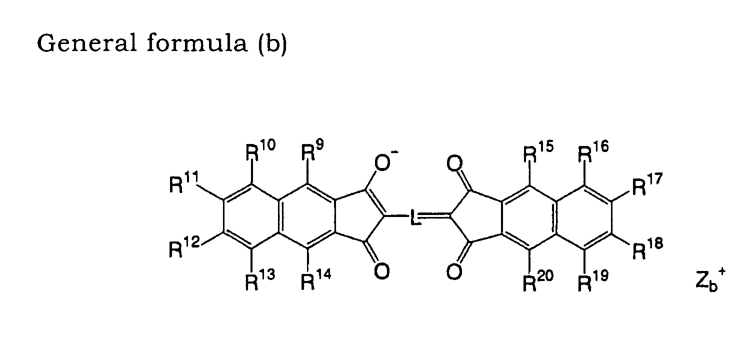

In general formula (b), L represents a methine chain having 7 or more conjugated carbon atoms, and the methine chain may have one or more substituent. The substituents may be bonded to each other to form a cyclic structure. Zb⁺ represents a counter cation. Preferable examples of the counter cation include ammonium, iodonium, sulfonium, phosphonium and pyridinium ions, and alkali metal cations (such as Ni⁺, K⁺ and Li⁺).

R⁹ to R¹⁴ and R¹⁵ to R²⁰ each independently represents a substituent selected from hydrogen atom, halogen atom, and cyano, alkyl, aryl, alkenyl, alkynyl, carbonyl, thio, sulfonyl, sulfinyl, oxy and amino groups; or a substituent obtained by combining two or three from among these substituents. Two or three out of R⁹ to R¹⁴ and R¹⁵ to R²⁰ may be bonded to each other to form a cyclic structure.

A dye wherein L in general formula (b) represents a methine chain having 7 conjugated carbon atoms, and each of R⁹ to R¹⁴ and R¹⁵ to R²⁰ represents a hydrogen atom, is preferable since such a dye can be easily obtained and exhibits advantageous effects.

Specific examples of the dye represented by general formula (b), and which can be preferably used in the invention, are illustrated below.

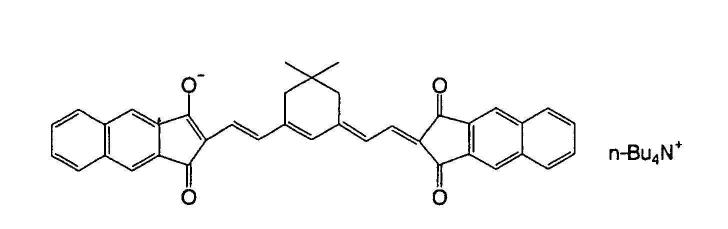

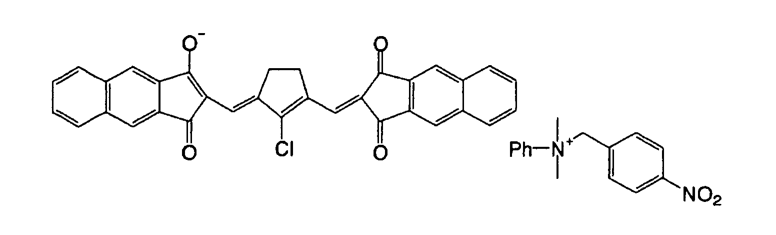

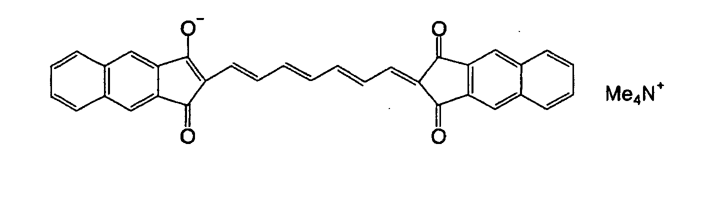

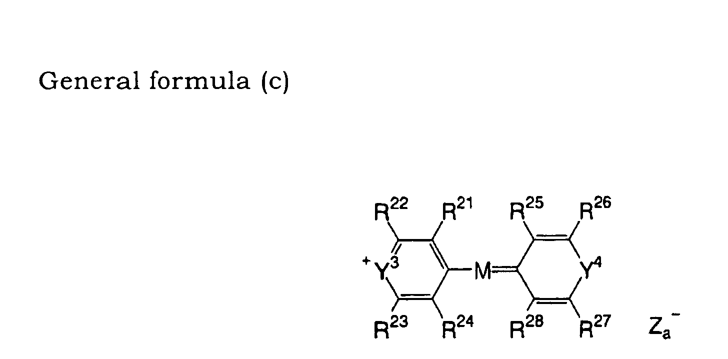

In general formula (c), Y³ and Y⁴ each independently represent an oxygen, sulfur, selenium or tellurium atom; M represents a methine chain having 5 or more conjugated carbon atoms; R²¹ to R²⁴ and R²⁵ to R²⁸, which may be the same or different, each represents a hydrogen or halogen atom, or a cyano, alkyl, aryl, alkenyl, alkynyl, carbonyl, thio, sulfonyl, sulfinyl, oxy or amino group; and Za⁻ represents a counter anion, and has the same meaning as Za⁻ in general formula (a).

Specific examples of the dye which is represented by general formula (c) and which can be preferably used in the invention, are illustrated below.

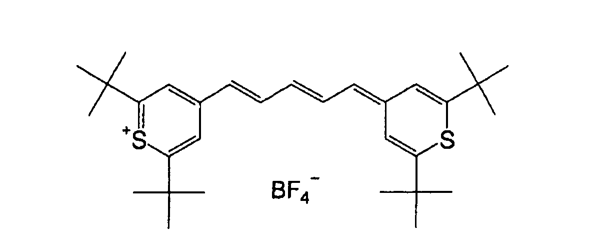

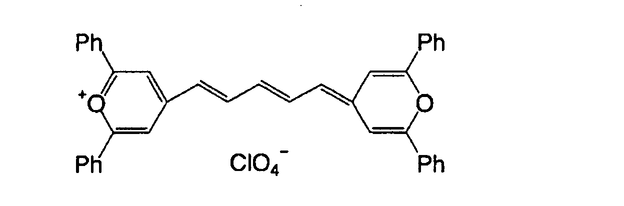

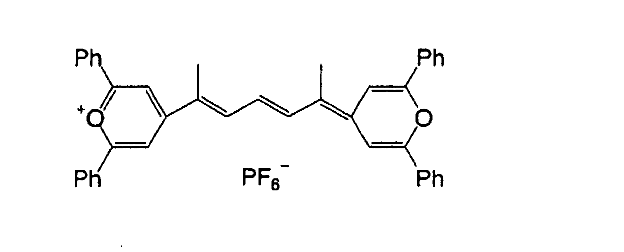

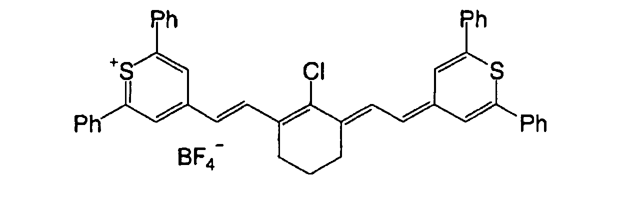

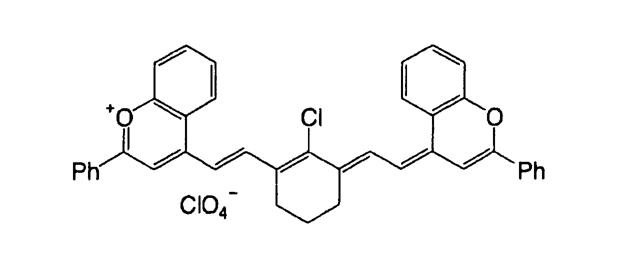

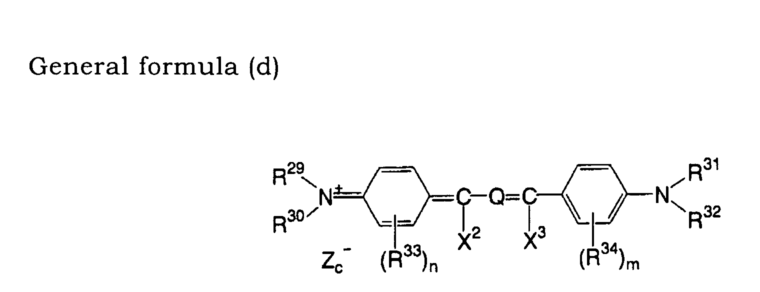

In general formula (d), R²⁹ to R³¹ each independently represents a hydrogen atom, an alkyl group or an aryl group; R³³ and R³⁴ each independently represents an alkyl group, a substituted oxy group, or a halogen atom; n and m each independently represents an integer of 0 to 4; and R²⁹ and R³⁰, or R³¹ and R³² may be bonded to each other to form a ring, or R²⁹ and/or R³⁰ may be bonded to R³³ to form a ring and R³¹ and/or R³² may be bonded to R³⁴ to form a ring. When plural R³³'s and R³⁴'s are present, R³³'s may be bonded to each other to form a ring, or R³⁴'s may be bonded to each other to form a ring.

X² and X³ each independently represents a hydrogen atom, an alkyl group or an aryl group, and at least one of X² and X³ represents a hydrogen atom or an alkyl group.

Q represents a trimethine group or a pentamethine group which may have a substituent, and may be combined with an bivalent organic group to form a cyclic structure. Zc⁻ represents a counter anion and has the same meanings as Za⁻ in general formula (a).

Specific examples of the dye represented by general formula (d) and which can be preferably used in the invention, are illustrated below.

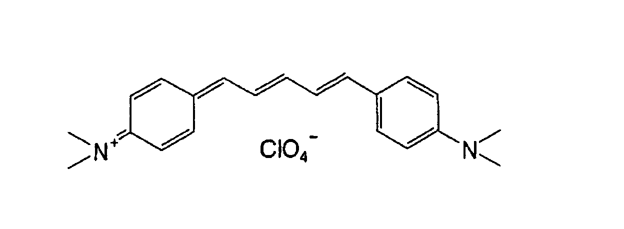

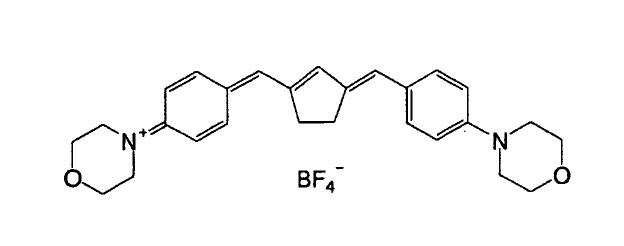

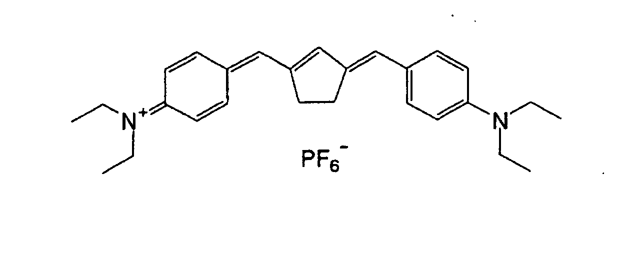

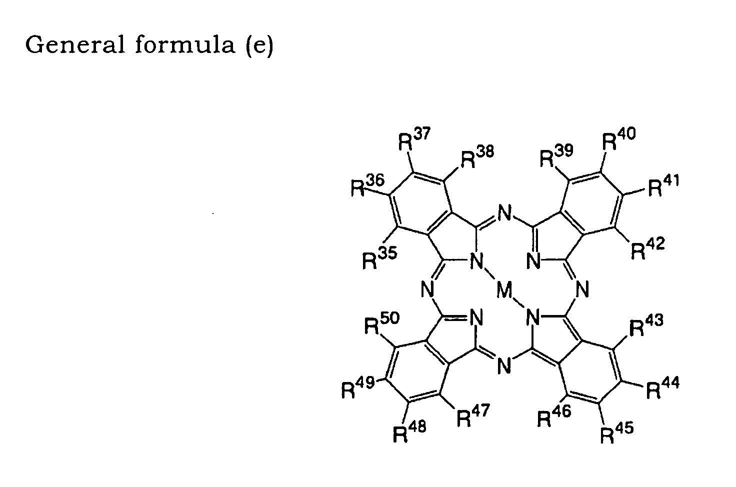

In general formula (e), R³⁵ to R⁵⁰ each independently represents a hydrogen or halogen atom, or a cyano, alkyl, aryl, alkenyl, alkynyl, hydroxyl, carbonyl, thio, sulfonyl, sulfinyl, oxy or amino group, or an onium salt structure, each of which may have a substituent; M represents two hydrogen atoms, a metal atom, a halo metal group, or an oxy metal group. Examples of the metal contained therein include atoms in IA, IIA, IIIB and IVB groups in the periodic table, transition metals in the first, second and third periods therein, and lanthanoid elements. Among these examples, preferable are copper, magnesium, iron, zinc, cobalt, aluminum, titanium, and vanadium.

Specific examples of the dye represented by general formula (e) and which can be preferably used in the invention, are illustrated below.

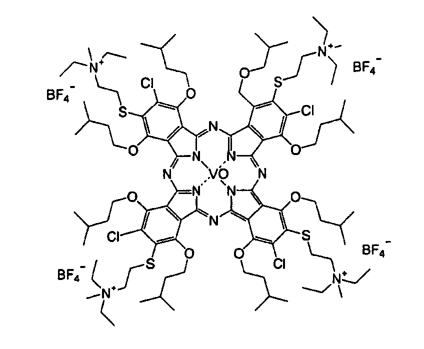

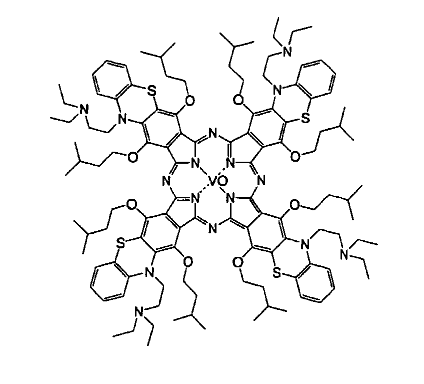

The pigment used as the infrared absorbent in the invention may be a commercially available pigment or a pigment described in publications such as Color Index (C.I.) Handbook, "Latest Pigment Handbook" (edited by Japan Pigment Technique Association, and published in 1977), "Latest Pigment Applied Technique" (by CMC Publishing Co., Ltd. in 1986), and "Printing Ink Technique" (by CMC Publishing Co., Ltd. in 1984).

Examples of the pigment include black pigments, yellow pigments, orange pigments, brown pigments, red pigments, purple pigments, blue pigments, green pigments, fluorescent pigments, metal powder pigments, and polymer-bonded dyes. Specifically, the following can be used: insoluble azo pigments, azo lake pigments, condensed azo pigments, chelate azo pigments, phthalocyanine pigments, anthraquinone pigments, perylene and perynone pigments, thioindigo pigments, quinacridone pigments, dioxazine pigments, isoindolinone pigments, quinophthalone pigments, dyeing lake pigments, azine pigments, nitroso pigments, nitro pigments, natural pigments, fluorescent pigments, inorganic pigments, and carbon black. Among these pigments, carbon black is preferable.

These pigments may be used with or without surface treatment. Examples of surface treatment include a method of coating the surface of the pigments with resin or wax; a method of adhering a surfactant onto the surface; and a method of bonding a reactive material (such as a silane coupling agent, an epoxy compound, or a polyisocyanate) to the pigment surface. The surface treatment methods are described in "Nature and Application of Metal Soap" (Saiwai Shobo), "Printing Ink Technique" (by CMC Publishing Co., Ltd. in 1984). And "Latest Pigment Applied Technique" (by CMC Publishing Co., Ltd. in 1986.

The particle size of the pigment is preferably from 0.01 to 10 µm, more preferably from 0.05 to 1 µm, and even more preferably from 0.1 to 1 µm. When a particle size is within the preferable range, a superior dispersion stability of the pigment in the photosensitive composition can be obtained, whereby, when the photosensitive composition of the invention is used for a recording layer of the photosensitive printing plate precursor, it is possible to form a homogeneous recording layer.

The method for dispersing the pigment may be a known dispersing technique used to produce ink or toner. Examples of a dispersing machine, which can be used, include an ultrasonic disperser, a sand mill, an attriter, a pearl mill, a super mill, a ball mill, an impeller, a disperser, a KD mill, a colloid mill, a dynatron, a three-roll mill, and a pressing kneader. Details are described in "Latest Pigment Applied Technique" (by CMC Publishing Co., Ltd. in 1986).

From the viewpoints of sensitivity, uniformity of the film to be formed and durability, the pigment or dye can be added to the photosensitive composition in a ratio of 0.01 to 50%, preferably 0.1 to 10%, and more preferably 0.5 to 10% (in the case of the dye) or 0.1 to 10% (in the case of pigment) by mass, relative to the total solid contents which constitute the photosensitive composition.

### [Other components]

At the time of forming the photosensitive layer of an image recording material of the invention, a variety of additives may optionally be added. Substances such as onium salts, o-quinonediazido compounds, and sulfonic acid alkyl esters, which are thermally decomposable and substantially suppress the solubility of alkali-soluble resins in the state that the substances are not decomposed (i.e., decomposable and dissolution suppressing agent), are preferably used, in particular, for improving the dissolution inhibiting property of the image forming portions to the developer. As the decomposable and dissolution suppressing agent, preferable examples thereof include onium salts such as diazonium salts, iodonium salts, sulfonium salts, and ammonium salts and o-quinonediazido compounds. Among these examples, onium salts such as diazonium salts, iodonium salts and sulfonium salts are more preferable, and diazonium salts are especially preferable as the thermally decomposable and dissolution suppressing agent.

Preferable examples of the onium salt used in the invention include diazonium salts described in S. I. Schlesinger, Photogr. Sci. Eng., 18, 387 (1974), T. S. Bal et al., Polymer, 21, 423 (1980), and JP-A No. 5-158230; ammonium salts described in U.S. Patent Nos. 4,069,055 and 4,069,056, and JP-A No. 3-140140; phosphonium salts described in D. C. Necker et al., Macromolecules, 17, 2468 (1984), C. S. Wen et al., Teh, Proc. Conf. Rad. Curing ASIA, p478 Tokyo, Oct (1988), and U.S. Patent Nos. 4,069,055 and 4,069,056; iodonium salts described in J. V. Crivello et al., Macromolecules, 10 (6), 1307 (1977), Chem. & Eng. News, Nov. 28, p31 (1988), EP No. 104,143, U.S. Patent Nos. 5,041,358 and 4,491,628, and JP-A Nos. 2-150848 and 2-296514; sulfonium salts described in J. V. Crivello et al., Polymer J. 17, 73 (1985), J. V. Crivello et al., J. Org. Chem., 43, 3055 (1978), W. R. Watt et al., J. Polymer Sci., Polymer Chem. Ed., 22, 1789 (1984), J. V. Crivello et al., Polymer Bull., 14, 279 (1985), J. V. Crivello et al., Macromolecules, 14 (5), 1141 (1981), J. V. Crivello et al., J. Polymer Sci., Polymer Chem. Ed., 17, 2877 (1979), EP Nos. 370,693, 233,567, 297,443 and 297,442, U.S. Patent Nos. 4,933,377, 3,902,114, 5,041,358, 4,491,628, 4,760,013, 4,734,444 and 2,833,827, and DE Patent Nos. 2,904,626, 3,604,580 and 3,604,581; selenonium salts described in J. V. Crivello et al., Macromolecules, 10 (6), 1307 (1977), J. V. Crivello et al., J. Polymer Sci., Polymer Chem. Ed., 17, 1047 (1979); arsonium salts described in C. S. Wen et al., and The Proc. Conf. Rad. Curing ASIA, p478, Tokyo, Oct (1988).

Among such onium salts, diazonium salts are particularly preferable from the viewpoints of both their capacity of hindering dissolution, and their thermal decomposability. The diazonium salts represented by general formula (I) in the JP-A No. 5-158230 and the diazonium salts represented by general formula (1) in JP-A No. 11-143064 are more preferable, and diazonium salts represented by general formula (1) in the JP-A No. 11-143064, which have low absorption wavelength peaks within the visible ray range, are most preferable.

Examples of the counter ion of the onium salt include tetrafluoroboric acid, hexafluorophosphoric acid, triisopropylnaphthalenesulfonic acid, 5-nitro-o-toluenesulfonic acid, 5-sulfosalicylic acid, 2,5-dimethylbenzenesulfonic acid, 2,4,6-trimethylbenzenesulfonic acid, 2-nitrobenzenesulfonic acid, 3-chlorobenzenesulfonic acid, 3-bromobenzenesulfonic acid, 2-fluorocaprylnaphthalenesulfonic acid, dodecylbenzenesulfonic acid, 1-naphthol-5-sulfonic acid, 2-methoxy-4-hydroxy-5-benzoyl-benzenesulfonic acid, and p-toluenesulfonic acid. Among these examples, hexafluorophosphoric acid, and alkylaromatic sulfonic acids such as triisopropylnaphthalenesulfonic acid and 2,5-dimethylbezenesulfonic acid are particularly preferable.

The quinonediazide is preferably an o-quinonediazide compound. The o-quinonediazide compound used in the invention is a compound having at least one o-quinonediazide group and having an alkali-solubility increased by being thermally decomposed. The compound may be any one of compounds having various structures.

In other words, the o-quinonediazide compound assists the solubility of the photosensitive material both from the viewpoint of the effects of being thermally decomposed, and thereby losing the function of suppressing the dissolution of the binder, and the effect that the o-quinonediazide itself is changed into an alkali-soluble material.

Preferable examples of the o-quinonediazide compound used in the invention include compounds described in J. Coser, "Light-Sensitive Systems" (John Wiley & Sons. Inc.), pp. 339-352. Particularly preferable are sulfonic acid esters or sulfonamides of o-quinonediazide made to react with various aromatic polyhydroxy compounds or with aromatic amino compounds.

Further preferable examples include an ester made from benzoquinone-(1,2)-diazidesulfonic acid chloride or naphthoquinone-(1,2)-diazide-5-sulfonic acid chloride and pyrogallol-acetone resin, as described in JP-B No. 43-28403; and an ester made from benzoquinone-(1,2)-diazidesulfonic acid chloride or naphthoquinone-(1,2)-diazide-5-sulfonic acid chloride and phenolformaldehyde resin.

Additional preferable examples include an ester made from naphthoquinone-(1,2)-diazide-4-sulfonic acid chloride and phenolformaldehyde resin or cresol-formaldehyde resin; and an ester made from naphthoquinone-(1,2)-diazide-4-sulfonic acid chloride and pyrogallol-acetone resin.

Other useful o-quinonediazide compounds are reported in unexamined or examined patent documents, examples of which include JP-A Nos. 47-5303, 48-63802, 48-63803, 48-96575, 49-38701 and 48-13354, JP-B No. 41-11222, 45-9610 and 49-17481, U.S. Patent Nos. 2,797,213, 3,454,400, 3,544,323, 3,573,917, 3,674,495 and 3,785,825, GB Patent Nos. 1,227,602, 1,251,345, 1,267,005, 1,329,888 and 1,330,932, and DE Patent No. 854,890.

When the photosensitive composition of the invention is used as a recording layer of a planographic printing plate precursor, the amount of onium salt and/or o-quinonediazide compound added as the decomposable dissolution suppresser(s) is preferably from 0.1 to 10%, more preferably from 0.1 to 5%, and even more preferably from 0.2 to 2% by relative to the total solid contents of the recording layer. The onium salts and the o-quinonediazide compounds may be used either independently or in the form of mixtures of two or more thereof.

The amount of additives other than the o-quinonediazide compound added is preferably from 0 to 5%, more preferably from 0 to 2%, and even more preferably from 0.1 to 1.5% by mass. The additives and the binder used in the invention are preferably incorporated into the same layer.

A dissolution suppresser having no decomposability may be used in combination. Preferable examples thereof include sulfonic acid esters, phosphoric acid esters, aromatic carboxylic acid esters, aromatic disulfones, carboxylic acid anhydrides, aromatic ketones, aromatic aldehydes, aromatic amines, and aromatic ethers, details of which are described in JP-A No. 10-268512; acidic color-developable dyes which have a lactone skeleton, an N,N-diarylamide skeleton or a diarylmethylimino skeleton and also function as a coloring agent, details of which are described in JP-A No. 11-190903; and nonionic surfactants described, details of which are described in JP-A No. 2000-105454.

In order to strengthen discrimination of images to be obtained (discrimination of hydrophobicity and hydrophilicity), or to improve the resistance of the surface against scratches, the following also may be used: a polymer containing, as a polymerization component, a (meth)acrylic monomer having in the 2 or 3 perfluoroalkyl groups having 3 to 20 carbon atoms. When the photosensitive composition of the invention is used as a recording layer of a planographic printing plate precursor, in relation to the total solid contents of the recording layer, the amount of this compound added is preferably from 0.1 to 10%, and more preferably from 0.5 to 5% by mass.

In order to provide the photosensitive composition of the invention with resistance against scaratches, a compound for lowering the static friction coefficient of the surface may be added to the composition. Specific examples thereof include long-chain alkyl carboxylic acid esters as described in U.S. Patent No. 6,117,913. When the photosensitive composition of the invention is used as a recording layer of a planographic printing plate precursor, in relation to the total solid contents of the recording layer, the amount of such a compound added is preferably from 0.1 to 10%, and more preferably from 0.5 to 5% by mass.

The photosensitive composition of the invention may, whenever necessary, contain a compound having an acidic group of low-molecular weight. Examples of such an acidic group include sulfonic acid, carboxylic acid and phosphoric acid groups. Compounds having a sulfonic acid group are particularly preferable. Specific examples include aromatic sulfonic acids and aliphatic sulfonic acids such as p-toluenesulfonic acid and naphthalenesulfonic acid.

In order to enhance sensitivity, the photosensitive composition may also contain a cyclic acid anhydride, a phenolic compound, or an organic acid.

Examples of cyclic acid anhydride include phthalic anhydride, tetrahydrophthalic anhydride, hexahydrophthalic anhydride, 3,6-endooxy-Δ4-tetrahydrophthalic anhydride, tetrachlorophthalic anhydride, maleic anhydride, chloromaleic anhydride, α-phenylmaleic anhydride, succinic anhydride, and pyromellitic anhydride which are described in U.S. Patent No. 4,115,128.

Examples of phenolic compound include bisphenol A, p-nitrophenol, p-ethoxyphenol, 2,4,4'-trihydroxybenzophenone, 2,3,4-trihydroxybenzophenone, 4-hydroxybenzophenone, 4,4',4"-trihydroxytriphenylmethane, 4,4',3",4"-tetrahydroxy-3,5,3',5'-tetramethyltriphenylmethane.

Examples of the organic acid include sulfonic acids, sulfonic acids, alkylsulfuric acids, phosphonic acids, phosphates, and carboxylic acids, which are described in JP-A No. 60-88942 or 2-96755. Specific examples thereof include p-toluenesulfonic acid, dodecylbenzenesulfonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluic acid, 3,4-dimethoxybenzoic acid, phthalic acid, terephthalic acid, 4-cyclohexene-1,2-dicarboxylic acid, erucic acid, lauric acid, n-undecanoic acid, and ascorbic acid.

When the cyclic acid anhydride, the phenol or the organic acid is added to a recording layer of a planographic printing plate precursor, the ratio thereof in the recording layer is preferably from 0.05 to 20%, more preferably from 0.1 to 15%, and even more preferably from 0.1 to 10% by mass.

When the photosensitive composition according to the invention is used in a recording layer coating solution for a planographic printing plate precursor, in order to enhance stability in processes which affect conditions of developing, the following can be added: nonionic surfactants as described in JP-A Nos. 62-251740 and 3-208514; amphoteric surfactants as described in JP-A Nos. 59-121044 and 4-13149; siloxane compounds as described in EP No. 950517; and copolymers made from a fluorine-containing monomer as described in JP-A No. 11-288093.

Specific examples of nonionic surfactants include sorbitan tristearate, sorbitan monopalmitate, sorbitan trioleate, monoglyceride stearate, and polyoxyethylene nonyl phenyl ether. Specific examples of amphoteric surfactants include alkyldi(aminoethyl)glycine, alkylpolyaminoethylglycine hydrochloride, 2-alkyl-N-carboxyethyl-N-hydroxyethylimidazolinium betaine and N-tetradecyl-N,N'-betaine type surfactants (trade name: "Amolgen K", manufactured by Dai-ichi Kogyo Seiyaku Co., Ltd.).

The siloxane compounds are preferably block copolymers made from dimethylsiloxane and polyalkylene oxide. Specific examples thereof include polyalkylene oxide modified silicones (trade names: DBE-224, DBE-621, DBE-712, DBE-732, and DBE-534, manufactured by Chisso Corporation; trade name: Tego Glide 100, manufactured by Tego Co., Ltd.).

The content of the nonionic surfactant and/or the amphoteric surfactant in the photosensitive composition is preferably from 0.05 to 15% by mass, and more preferably from 0.1 to 5% by mass.

To the photosensitive composition of the invention may be added a printing-out agent for obtaining a visible image immediately after the photosensitive composition of the invention has been heated by exposure to light, or a dye or pigment as an image coloring agent.

A typical example of a printing-out agent is a combination of a compound which is heated by exposure to light, thereby emitting an acid (an optically acid-generating agent), and an organic dye which can form salts (salt formable organic dye).

Specific examples thereof include combinations of an o-naphthoquinonediazide-4-sulfonic acid halogenide with a salt-formable organic dye, described in JP-A Nos. 50-36209 and 53-8128; and combinations of a trihalomethyl compound with a salt-formable organic dye, described in each of JP-A Nos. 53-36223, 54-74728, 60-3626, 61-143748, 61-151644 and 63-58440.

The trihalomethyl compound is classified into an oxazol compound or a triazine compound. Both of the compounds provide excellent in stability over the passage of time and produce a vivid printed-out image.

As the image coloring agent, a dye different from the above-mentioned salt-formable organic dye may be used. Preferable examples of such a dye, and of the salt-formable organic dye, include oil-soluble dyes and basic dyes.

Specific examples thereof include Oil yellow #101, Oil Yellow #103, Oil Pink #312, Oil Green BG, Oil Blue BOS, Oil Blue #603, Oil Black BY, Oil Black BS, and Oil Black T-505 (each of which is manufactured by Orient Chemical Industries Ltd.); Victoria Pure Blue, Crystal Violet (CI42555), Methyl Violet (CI42535), Ethyl Violet, Rhodamine B (CI145170B), Malachite Green (CI42000), and Methylene Blue (CI52015).

Dyes described in JP-A No. 62-293247 are particularly preferable. These dyes may be added to the photosensitive composition at a ratio of 0.01 to 10% by mass, and preferably 0.1 to 3% by mass, relative to the total solid contents therein.

Whenever necessary, a plasticizer may be added to the photosensitive composition of the invention to give flexibility to a coating film made from the composition. Examples of the plasticizer include oligomers and polymers of butyl phthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl olete, and acrylic acid and methacrylic acid.

In addition to the above, the following may be appropriately added to the composition, depending on the objective: an epoxy compound; a vinyl ether; a phenol compound having a hydroxymethyl group and a phenol compound having an alkoxymethyl group, described in JP-A No. 8-276558; and a cross-linkable compound having an effect of suppressing dissolution in an alkali, described in JP-A No. 11-160860, and which was previously proposed by the present inventors.

The photosensitive layer of the image recording material of the invention obtained in such a manner as described above is excellent in the film formability and film strength and exhibits high alkali-solubility at the exposed portions where exposure to IR rays has been effected.

To produce the image recording material of the invention, the respective components of the above-mentioned photosensitive layer are dissolved in a solvent and applied onto the intermediate layer formed on the anodized aluminum support, to form the photosensitive layer. Further, depending on the purposes, a protective layer, a resin intermediate layer, and a back coat layer, which will be described later, may be formed in a similar manner.

The solvent to be used here may include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulfurane, γ-butyrolactone, and toluene, but the solvent is not limited to these examples. These solvents may be used alone or in form of mixture.

The concentration of the above-mentioned components (the total solid content including the additives) in the solvent is preferably 1 to 50% by weight.

In general, the coated amount (the solid content) of the photosensitive layer after being coated and dried is preferably 0.5 to 5.0 g/m² for the planographic printing plate precursor, although the amount may vary depending on the applications. The smaller the coating amount, the larger the apparent sensitivity but results in the poorer coating properties of the photosensitive film.

As the method for coating, a various kinds of methods can be employed. Examples thereof include bar coater coating, rotation coating, spray coating, curtain coating, dip coating, air knife coating, blade coating, and roll coating.

### [Resin intermediate layer]

Whenever necessary, a resin intermediate layer may be formed between the support and the recording layer in the planographic printing plate precursor to which the photosensitive composition of the invention is applied.

This resin intermediate layer, which is made of a polymer, functions as a heat insulating layer. Thus, heat generated by exposing the precursor to an infrared laser does not diffuse into the support and is effectively used. Consequently, the planographic printing plate precursor has an advantage insofar the recording layer can attain a high degree of sensitivity. When this resin intermediate layer is formed, the recording layer is positioned so as a surface is exposed to light, or the recording layer is positioned near the surface, and the sensitivity to the infrared laser is thereby satisfactorily maintained.

In unexposed portions of the recording layer, the recording layer itself, which the alkali developer does not penetrate, functions as a protective layer for the resin intermediate layer. Accordingly, development stability of the printing plate precursor is secured to a satisfactory level and, in addition, images superior in discrimination are formed. Moreover, it is believed that over the passage of time of the images can be maintained.

On the other hand, in the exposed portions, components of the recording layer, the dissolution-suppressing function of which has been nullified, are speedily dissolved and dispersed into the developer, and, further, the resin intermediate layer, which is positioned adjacent to the support, is made mainly of an alkali-soluble resin. Accordingly, the exposed portions exhibit satisfactory solubility in the developer. Therefore, for example, even when a developer whose activity has been lowered is used, the intermediate resin layer is rapidly dissolved without leaving any portion of the layer remaining behind. This fact contributes to an improvement in the developability of the printing plate precursor, and in this way the resin intermediate layer is useful.

The resin intermediate layer is formed as a layer made mainly of alkali-soluble resin. In order to distinguish the boundary between the recording layer and the resin intermediate layer clear, it is preferable to use for the main component of the intermediate layer an alkali-soluble resin which is different from that used in the recording layer.

Preferable examples of the alkali-soluble resin used in the resin intermediate layer include alkali-soluble resins having units exhibiting high polarity, such as copolymer of N-(p-aminosulfonylphenyl)(meth)acrylamide, alkyl (meth)acrylate and acrylonitrile, copolymer of 4-maleimidebenzenesulfonamide, and styrene, and copolymer of (meth)acrylic acid, N-phenylmaleimide and (meth)acrylamide. However, the alkali-soluble resin is not limited thereto.

### [Support]

As the support to be used for the image recording material of the invention, a metal plate of such as aluminum, zinc, and copper is preferable since the support is required to be plate-like material stably in the size and have sufficient heat resistance for standing the burning treatment described below. Above all, an aluminum plate which is excellent in size stability and relatively economical is particularly preferable. Further, the support of the invention is most preferably the aluminum plate subjected to anodization.

The preferable aluminum plate is a pure aluminum plate, or an alloy plate containing aluminum as a main component and trace amounts of different elements, or a plastic film on which aluminum is laminated or deposited by evaporation. The different element which may be contained in the aluminum alloy are silicon, iron, manganese, copper, magnesium, chromium, zinc, bismuth, nickel and titanium. The content of each element in the alloy is at highest 10% by weight. Particularly preferable aluminum in the invention is pure aluminum, but completely pure aluminum is difficult to produce in relation to refining technique and therefore, slight amounts of different elements may be mixed.

Accordingly, an aluminum plate to be used as a support does not need to have a specific composition, and conventionally known aluminum plates can be used. The thickness of the aluminum plate to be used in the invention is to be 0.1 mm to 0.6 mm, preferably 0.15 mm to 0.4 mm, and particularly preferably 0.2 mm to 0.3 mm.

Prior to the surface-roughening of the aluminum plate, to remove rolling oil on the surface if desired, degreasing treatment is carried out by, for example, a surfactant, an organic solvent, or an aqueous alkaline solution. The surface-roughening of the surface of the aluminum plate can be carried out by a variety of methods, for example, a method of mechanically roughening a surface, a method of electrochemically dissolving and roughening a surface, and a method of chemically selectively dissolving a surface. As the mechanical method, known methods such as a ball grounding method, a brush grounding method, a blast polishing method and a buffing method can be employed. As the electrochemical surface-roughening method, there are methods for surface roughening by using a.c. electric current or d.c. electric current in a hydrochloric acid or nitric acid electrolytic solution. Also, methods, as described in JP-A No. 54-63902, in which both methods are combined each other, can be employed.

After the aluminum plate has been surface-roughened in such a manner, the aluminum plate is subjected to alkali etching treatment and neutralization based on the necessity, anodization treatment is carried out to increase the water-retention property and the wear resistance of the surface. In the invention, it is required to use an aluminum plate subjected to the anodization treatment, which will be described later, as the support. As the electrolytes to be used for the anodization of the aluminum plate, a variety of electrolytes for forming porous oxide coating can be used and in general, sulfuric acid, phosphoric acid, oxalic acid, chromic acid and mixtures thereof can be used. The concentration of each electrolyte can properly be determined depending on the types of the electrolytes.

While the anodizing process conditions are not uniquely defined since they differ depending on the electrolyte used, the proper condition usually comprise 1 to 80% by mass of the electrolyte concentration, 5 to 70°C of the liquid temperature, 5 to 60 A/dm² of the current density, 1 to 100 V of the voltage, and 10 seconds to 5 minutes of the electrolysis time. Printing durability may become insufficient when the amount of the anodized film is less than 1.0 g/m², resulting in the non-image portion being easily damaged so that so-called "scratch contamination" is readily caused due to adhesion of ink at the scratched portions during the printing process. A hydrophilicity process is applied, if necessary, to the surface of aluminum after applying anodizing process. An example of the hydrophilicity process is to treat with an alkali metal silicate solution (for example, an aqueous sodium silicate solution) as disclosed in U.S. Patent Nos. 2,714,066, 3,181,461, 3,280,734 and 3,902,734. The substrate is immersed in the aqueous sodium silicate solution or subjected to electrolysis in these methods. Other examples available include treating with potassium fluorozirconic acid as disclosed in Japanese Patent Application Publication (JP-B) No. 36-22063, and treating with polyvinyl sulfonic acid as disclosed in U.S. Patent Nos. 3,276,868, 4,153,461 and 4,689,272.

While the intermediate layer and positive photosensitive layer are sequentially deposited on the substrate after the anodizing process in the image recording material of the invention, an undercoat layer may be provided, if necessary, between the substrate and intermediate layer.

A variety of organic compounds may be used as the components of the undercoat layer and the compounds are selected from, for example, carboxymethyl cellulose, dextrin, Gum Arabic, amino group-containing phosphonic acids such as 2-aminoethylphosphonic acid; organic phosphonic acid such as (un)substituted phenylphosphonic acid, naphthylphosphonic acid, alkylphosphonic acid, glycelophosphonic acid, methylene disphosphonic acid, and ethylene disphosphonic acid; organic phosphoric acid such as (un)substituted phenylphosphoric acid, naphthylphosphoric acid, alkylphosphoric acid, and glycelophosphoric acid; organic phosphinic acid such as (un)substituted phenylphosphinic acid, naphthylphosphinic acid, alkylphosphinic acid, and glycelophosphinic acid; aminoacids such as glycine and β-alanine; and hydroxy group-containing amine hydrochloric acid salts such as triethanolamine hydrochloric acid salt. Two or more of these compounds may be used in combination.

The organic undercoat layer may be formed by the following method. Examples of the method for forming the organic undercoat layer include a method of applying a solution obtained by dissolving the above-mentioned organic compounds in water or an organic solvent such as methanol, ethanol, or methyl ethyl ketone, or a mixture thereof to an aluminum plate and drying the solution, and a method of immersing an aluminum plate in the solution obtained by dissolving the above-mentioned organic compounds in water or an organic solvent such as methanol, ethanol, or methyl ethyl ketone, or a mixture thereof so that the support absorbs the above-mentioned compounds, and then washing with water or the like and drying the support. In the case of the former method, the solution with a concentration of the above-mentioned organic compounds in a range of 0.005 to 10% by weight can be applied by a variety of methods. In the case of the latter method, the concentration of the solution is 0.01 to 20% by weight, preferably 0.05 to 5% by weight and the immersion temperature is 20 to 90°C, preferably 25 to 50°C, and the immersion duration is 0.1 second to 20 minutes, preferably 2 seconds to 1 minute. The solution to be used for the methods may be adjusted to have pH in a range of 1 to 12 by a basic substance such as ammonia, triethylamine, and potassium hydroxide and an acidic substance such as hydrochloric acid and phosphoric acid. Further, a yellow dye may be added for tone reproducibility improvement for the image recording material.

The coating amount of the organic undercoat layer is properly 2 to 200 mg/m², preferably 5 to 100 mg/m². If the above-mentioned coating amount is less than 2 mg/m², or if the above-mentioned coating amount exceeds 200 mg/m², sufficient printing durability is not likely to be obtained.

The image recording material produced in the above-mentioned manner is preferably used as a planographic printing plate precursor. In general, a planographic printing plate precursor is subjected to image-wise exposure and development to use it as a planographic printing plate.

The light source of the light beam to be used for image-wise exposure is preferably a light source having light emitting wavelength in near IR and IR region. Solid state laser and semiconductor laser are particularly preferable.

As a developer or a replenisher for the image recording material of the invention, conventional aqueous alkaline solutions can be used.

Examples of the alkali agents include inorganic alkali agents such as sodium silicate, potassium silicate, sodium tertiary phosphate, potassium tertiary phosphate, ammonium tertiary phosphate, dibasic sodium phosphate, dibasic potassium phosphate, dibasic ammonium phosphate, sodium carbonate, potassium carbonate, ammonium carbonate, sodium hydrogen carbonate, potassium hydrogen carbonate, ammonium hydrogen carbonate, sodium borate, potassium borate, ammonium borate, sodium hydroxide, ammonium hydroxide, potassium hydroxide, and lithium hydroxide; and organic alkaline agent such as monomethylamine, dimethylamine, trimethylamine, monoethylamine, diethylamine, triethylamine, monoisoproylamine, diisopropylamine, triisopropylamine, n-butylamine, monoethanolamine, diethanolamine, triethanolamine, monoisopropanolamine, diisopropanolamine, ethylenimine, ethylenediamine, and pyridine. These alkali agents may be used alone or two or more of them in combination.

Particularly preferable developers among the alkali agents are aqueous silicate solutions such as sodium silicate and potassium silicate. The reason for that is because the developability can be adjusted depending on the ratio and the concentration of silicon oxide SiO₂, which is a component of the silicates, and alkali metal oxides M₂O, and alkalimetal silicates described in, for example JP-A No. 54-62004 and JP-B No. 57-7427 are efficiently used.

In the case of carrying out development by using an automatic developing apparatus, it is known that a large quantity of PS plates can be treated without replacing the developer in a developer tank for a long duration by adding, to the developer, aqueous solution (a replenisher) with a higher alkalinity than that of the developer. In the invention, this replenishing method is preferably employed. To promote or suppress the developability of the developer or the replenisher and improve the dispersion of development scum and affinity of the image forming portion of the printing plate to ink, a variety of surfactants and organic solvents may optionally be added.

As preferable surfactants, anionic, cationic, nonionic and amphoteric surfactants can be exemplified. Further, to the developer or the replenisher, reducing agents of such as hydroquinone, resorcin, sodium salt or potassium salt of inorganic acids such as sulfurous acid, hydrogen sulfurous acid, and further organic carboxylic acid, defoaming agents, and water hardening or softening agents may be added.

The printing plate treated by using the developer or the replenisher is washed with water and post-treated with rinsing solutions containing the surfactants or the like, and desensitizing solutions containing gum arabic and starch derivatives. The post-treatment of the image recording material of the invention can be carried out by using these treatments in combinations.

Recently, for rationalization or standardization of the printing plate production work in printing plate-producing or printing industries, automatic developing apparatuses for printing plates have been used widely. An automatic developing apparatuses generally comprise a development section and a post-treatment section. More specifically, an automatic developing apparatus includes a unit for transferring the printing plates, tanks for respective treatment solutions, and a spraying apparatuse. The automatic developing apparatus transfers the exposed printing plates horizontally and at the same time carries out development treatment by spraying the respective treatment solutions pumped up by pumps, to the printing plate, through spray nozzles. Recently, there is also known a method for carrying out treatment by transporting the printing plates by under-solution guide rolls while the printing plates are immersed in the treatment solution tanks filled with the treatment solutions. In such automatic treatment, the replenishers may be replenished to the respective treatment solutions depending on the treatment quantity, operation times, and the like. Alternatively, so-called disposable treatment method in which treatment is carried out using substantially unused treatment solutions can be employed.

In the case where the image recording material of the invention is used for a planographic printing plate precursor, the image recording material is imagewise exposed, developed, washed with water and/or rinsed and/or gum-coated to obtain a planographic printing plate. If unnecessary image portions (e.g. film edge trace of a master film) are present in the planographic printing plate, the unnecessary image portions are erased. Such erasing is preferably carried out by a method of applying an erasing solution as described in JP-B No. 2-13293 to the unnecessary image portions and washing with water after a prescribed duration. A method of radiating active light beam led through optical fibers to the unnecessary image portions and then carrying out development may also be employed.

The planographic printing plate produced in such a manner is coated with a desensitizing gum if necessary and supplied to printing steps. In a case where a planographic printing plate with further improved printing durability is to be obtained, burning treatment is optionally carried out.

In the case where the burning treatment of the planographic printing plate is carried out, it is preferable to treat, prior to the burning treatment, the planographic printing plate with surface conditioning solutions described in JP-B Nos. 61-2518 and 55-28062 and JP-A Nos. 62-31859 and 61-159655.

Examples of a method for effecting such a pre-burning treatment include a method of applying the surface conditioning solutions to the planographic printing plate by sponge or degreased cotton doped with the solutions, a method of immersing the printing plate in a vat filled with the surface conditioning solutions, a method of applying the surface conditioning solutions using automatic coaters. In a case where after application the amount of solution applied is made uniform with a squeegee or a squeegee roller, a better result can be obtained.

In general, the amount of surface-adjusting solution applied is suitably from 0.03 to 0.8 g/m² (dry mass). If necessary the planographic printing plate onto which the surface-adjusting solution is applied can be dried, and then the plate is heated to a high temperature by means of a burning processor (for example, a burning processor (BP-1300) sold by Fuji Photo Film Co., Ltd.) or the like. In this case, the heating temperature and the heating time, which depend on the kind of components forming the image, are preferably from 150 to 300°C and from 0.5 to 20 minutes, respectively.

In the case of using the planographic printing plate precursor of the invention, burning treatment in a temperature condition of 150 to 300°C, preferably 180 to 300°C, can improve the strength of the image portions and the adhesion strength between the photosensitive layer and the support through the intermediate layer, so that a planographic printing plate with excellent burning printing durability can be obtained.

If necessary, a planographic printing plate subjected to burning treatment can be subjected to treatments which have been conventionally conducted, such as a water-washing treatment and gum coating. However, in a case where a surface-adjusting solution containing a water soluble polymer compound or the like is used, the so-called desensitizing treatment (for example, gum coating) can be omitted. The planographic printing plate obtained as a result of such treatments is applied to an offset printing machine or to some other printing machine, and is used for printing on a great number of sheets.

### EXAMPLES

Hereinafter, the present invention will be described in detail by way of examples. However, the invention is not limited to these examples.

### [Production of support]

Supports 1 to 3 were produced from 0.3 mm-thick JIS-A-1050 aluminum plates by the following treatment.

### (a) Mechanical surface-roughening treatment

Mechanical surface roughening treatment was carried out by a rotating roller type nylon brush by supplying a suspension of an abrasive agent (silica sand) having a specific gravity of 1.12 and water as an abrasive slurry solution to the surface of the aluminum plate. The average particle size of the abrasive agent was 8 µm and the maximum particle size was 50 µm. The material of the nylon brush was 6·10 nylon with a hair length of 50 mm and a hair diameter of 0.3 mm. The nylon brush was produced by implanting hairs densely in holes formed in a stainless cylinder having a diameter of 300 mm. Three rotary brushes were employed. The distance between two supporting rollers (diameter: 200 mm) under the brush was 300 mm. The brush roller was pressed to the aluminum plate until the load was increased to a load higher by 7 kW than that before it was pressed to the aluminum plate. The rotation direction of the brush was the same as the direction of the movement of the aluminum plate. The rotation speed of the brush was 200 rpm.

### (b) Alkali etching treatment

The obtained aluminum plate was etched by spraying an aqueous NaOH solution (concentration: 26% by weight, aluminum ion concentration of 6.5% by weight) at 70°C to etch 6 g/m² of the aluminum plate, followed by washing with water by spraying.

### (c) Desmutting treatment

Desmutting treatment was carried out by spraying an aqueous 1% by weight nitric acid solution (containing 0.5 % by weight of aluminum ion) at 30°C, followed by washing with water by spraying. As the aqueous nitric acid solution, a waste solution obtained from the step of electrochemical surface roughening treatment by applying a.c. current in an aqueous nitric acid solution was used.

### (d) Electrochemical surface roughening treatment

Electrochemical surface roughening treatment was carried out continuously using an a.c. voltage of 60 Hz. The electrolytic solution was an aqueous solution containing 10.5 g/ L of nitric acid (including 5 g/L of aluminum ions) at 50°C. The a.c. power source had the waveform in which the time TP required for current value to reach a peak from 0 was 0.8 msec and the duty ratio was 1 : 1, and trapezoidal rectangular wave a.c. current was used to carry out electrochemical surface roughening treatment using a carbon electrode as a counter electrode. Ferrite was used as an auxiliary anode. The electrolytic bath employed was a radial cell type.

The current density was 30 A/dm² as a peak current, and the quantity of electricity was 220 C/dm² as the total quantity of electricity when the aluminum plate was an anode. 5 % of the current flowing from the power source was branched to the auxiliary electrode. Thereafter, the aluminum plate was washed with water by spraying.

### (e) Alkali etching treatment

Etching treatment was carried out by spraying a solution containing 26% by weight of caustic soda and 6.5% by weight of aluminum ions to the aluminum plate at 32°C to etch 0.20 g/cm² of the aluminum plate to remove the smut component primarily containing aluminum hydroxide generated when performing the foregoing electrochemical surface roughening treatment using a.c. current, and also to etch the edge part of the pits produced to thereby round the edge part. Thereafter, the aluminum plate was washed with water by spraying.

### (f) Desmutting treatment

Desmutting treatment was carried out by spraying an aqueous 15 % by weight nitric acid solution (including 4.5% by weight of aluminum ions) at 30°C, followed by washing with water by spraying. As the aqueous nitric acid solution used in the desmutting treatment, a waste solution obtained in the step of electrochemical surface roughening treatment by applying a.c. current in an aqueous nitric acid solution was used.

### (g) Electrochemical surface roughening treatment

Electrochemical surface roughening treatment was continuously carried out by applying an a.c. voltage of 60 Hz. In this case, the electrolytic solution was an aqueous solution containing 7.5 g/L of hydrochloric acid (including 5 g/L of aluminum ions) at 35°C. The a.c. power source had a trapezoidal rectangular waveform and a carbon electrode was used as a counter electrode to carry out electrochemical surface roughening treatment. Ferrite was used as an auxiliary anode. The electrolytic bath employed was a radial cell type.

The current density was 25 A/dm² as a peak current and the quantity of electricity was 50 C/dm² as the total quantity of electricity when the aluminum plate was an anode.

Thereafter, the aluminum plate was washed with water by spraying.

### (h) Alkali etching treatment

Etching treatment was carried out by spraying a solution containing 26% by weight of caustic soda and 6.5% by weight of aluminum ions to the aluminum plate at 32°C to etch 0.10 g/cm² of the aluminum plate to remove the smut component primarily containing aluminum hydroxide generated when performing the foregoing electrochemical surface roughening treatment using a.c. current, and also to etch the edge part of the pits produced to thereby round the edge part. Thereafter, the aluminum plate was washed with water by spraying.

### (i) Desmutting treatment

Desmutting treatment was carried out by spraying an aqueous solution containing 25 % by weight sulfuric acid solution (inluding 0.5% by weight of aluminum ions) at 60°C, followed by washing with water by spraying.

### (j) Anodization treatment

Sulfuric acid was used as the electrolytic solution. The electrolytic solution contained 170 g/L of sulfuric acid (including 0.5% by weight of aluminum ions) at 43°C. Thereafter, the aluminum plate was washed with water by spraying.

The current densities were respectively about 30 A/dm². The final anodized coating amount was 2.7 g/m².

### (k) Alkali metal silicate treatment

Alkali metal silicate treatment (silicate treatment) was carried out by immersing the above-mentioned aluminum support in an aqueous solution containing 1% by weight of No. 3 sodium silicate at 30°C for 10 seconds, followed by washing with water by spraying. The amount of silicate adhering to the support was 3.5 mg/m².

### <Support 1>

A support 1 was produced by successively carrying out the above-mentioned respective steps (a) to (j) so as to adjust the etching amount to 3.5 g/m².

### <Support 2>

A support 2 was produced in the same manner except that steps (g), (h), and (i) were omitted.

### <Support 3>

A support 3 was produced by successively carrying out the above-mentioned respective steps (a) to (k) so as to adjust the etching amount in step (e) to 3.5 g/m².

### (Formation of intermediate layer)

The following coating solution for intermediate layer formation was applied to the respective supports produced as described above and then dried at 80°C for 15 seconds to form intermediate layers. The supports, the intermediate layer polymers, and the intermediate layer coating amounts (mg/m²) after drying are shown in Table 1. The polymers of the intermediate layers shown in Table 1 were polymers described in specific examples (P-1 to P-15) of the above-mentioned specific polymers.

### <Coating solution for intermediate layer formation>

·Interlayer polymer amounts shown in

**Table 1**

| (compounds described in Table 1) | |
|---|---|
| ·Methanol | 100 g |
| ·Water | 1 g |

### [Examples 1 to 8]

The following photosensitive layer coating solution 1 was applied to the supports having the intermediate layers formed in the above-mentioned manner so as to adjust the coating amount to 1.4 g/m². Then, the coating solution was dried at 140°C for 100 seconds in PERFECT OVEN PH 200 manufactured by Tabai Co., with its Wind Control being set to 7, to obtain planographic printing plate precursors of the Examples and Comparative Examples.

### <Coating liquid of photosensitive layer 1>

| | |
|---|---|
| ·novolac resin (the resin listed in Table 1) | 0.9 g |
| ·ethyl methacrylate/ isobutyl methacrylate/methacrylic acid copolymer (35/35/30% by mole) | 0.10 g |
| ·light to heat conversion agent (cyanine dye A having the following structure) | 0.10 g |
| ·phthalic anhydride | 0.05 g |
| ·p-toluene sulfonic acid | 0.002 g |
| ·ethyl violet having a counter ion substituted with 6-hydroxy-β-naphthalene sulfonic acid | 0.02 g |
| ·fluorinated polymer (Defenser F-780F (solid content 30%), trade name, manufactured by Dainippon Ink & Chemicals Inc.) | 0.015 g |
| ·fluorinated polymer (Defenser F-781F (solid content 100%), trade name, Manufactured by Dainippon Ink & Chemicals Inc.) | 0.035 g |
| ·methylethyl ketone | 12 g |

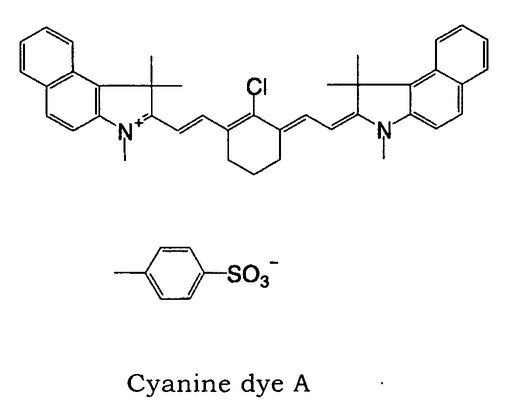

The novolac resin used for the coating liquid of the photosensitive layer is as follows:
novolac resin 1: m/p-cresol (6/4), weight average molecular weight of 7,000, residual monomer of 0.5% by mass
novolac resin 2: 2,3-xylenol/m/p-cresol (1/4/5), weight average molecular weight of 8,000, residual monomer of 0.4% by mass
novolac resin 3: phenol novolac, weight average molecular weight of 8,000, residual monomer of 0.8% by mass

### [Comparative Example 1]

The planographic printing plate precursor of Comparative Example 1 comprising a photosensitive layer was manufactured by the same method as in Example 1, except that the intermediate layer was not formed on the substrate 1 that had been formed in Example 1.

### [Comparative Examples 2 and 3]

The planographic printing plate precursors of Comparative Examples 2 and 3 each comprising a photosensitive layer and an intermediate layer therebelow were manufactured by the same method as in Example 1, except that the novolac resin 2 used for the photosensitive layer of Example 1 was replaced with the novolac resins 1 or 3, respectively.

### [Comparative Example 4]

The planographic printing plate precursor of Comparative Example 4 comprising a photosensitive layer and an intermediate layer therebelow was manufactured in the same manner as that of Example 1, except that the following coating liquid of the photosensitive layer 2 was used for producing a photosensitive layer.

| <Coating liquid of photosensitive layer 2> | |
|---|---|
| ·specific copolymer 1 (the copolymer obtained in the synthesis example 1 in Japanese Patent Application Laid-Open (JP-A) No. 11-44956) | 0.75 g |
| ·m,p-cresol/novolac (m/p ratio = 6/4, weight average molecular weight of 3,500, unreacted cresol content of 0.5% by mass) | 0.25 g |
| ·p-toluene sulfonic acid | 0.003 g |
| ·tetrahydrophthalic anhydride | 0.03 g |
| ·cyanine dye A (the structure above) | 0.017 g |
| ·dye in which the counter ion of victoria pure blue BOH is replaced with 1-naphthalene sulfonic acid anion | 0.015 g |
| ·fluorinated surfactant (trade name: Megaface F-177,) manufactured by Dainippon Ink & Chemicals, Inc.) | 0.05 g |
| ·γ-butyrolactone | 10 g |
| ·methylethyl ketone | 10 g |
| · 1-methoxy-2-propanol | 1 g |

### [Evaluation of polymer interaction]

5 % methanol solution A of the polymer used for the coating liquid of the intermediate layers of Examples and Comparative Examples, and 5 % of methanol solution B of the novolac resin used for the coating liquid of the photosensitive layer were prepared. Then, 1 mL of solution B was added to 1 mL of solution A with mixing at 25°C, and the change of the mixed solution was visually confirmed after 5 minutes.

When any one of turbidity of the mixed solution (to an extent capable of visually confirming that the mixed solution is more opaque than original solutions A and B), generation of white precipitates in the mixed solution, and gel formation in the mixed solution (to an extent capable of visually confirming insoluble gel solid) is observed, it was judged that the polymer interacts with the novolac resin (denoted by "O"). When neither of these phenomena were confirmed, it was evaluated that the polymer does not interact with the novolac resin (denoted by "×").

### [Evaluation of the pranographic printing plate precursor]

### (Exposure, development)

The above obtained respective image recording materials of the Examples and Comparative Examples were imagewise exposed at 10 W/250 rpm by using TREND SETTER 800 Quantum manufactured by Creo Co.. Then, the images were developed by an automatic developing apparatus LP-940 H comprising a development bath filled with a developer for PS, LH-DS, manufactured by Fuji Photo Film Co., Ltd. and charged under standard conditions and three baths filled with FP-2W (1:1), to obtain planographic printing plates.

### (Evaluation of chemical resistance)

A droplet of ABC blanket cleaner manufactured by Allied Co. was dropped by a dropper to the obtained respective planographic printing plates of the Examples and Comparative Examples and left to stand for 5 minutes. Thereafter, the planographic printing plates were washed with water. The degree of damage done to the photosensitive layers in the region where the droplet was dropped were visually observed and evaluated according to the following criteria.
A: The dropping region cannot be clearly observed.
B: The dropping region can be observed vaguely (i.e., the region has been
   slightly thinned)
C: The dropping region has been thinned
D: the photosensitive layer in the dropping region was completely dissolved.

### (Evaluation of printing durability)

The obtained planographic printing plates were used to carry out printing by black ink, DIC-GEOS (N) manufactured by Dainippon Ink and Chemicals, Inc. using a LITHRONE printing apparatus manufactured by Komori Corp.. The printing durability was evaluated, based on the number of printed sheets at the point where it could be observed visually that the density of the mat image had started to become lighter. Evaluation was made such that, the larger the number of printed sheets, the better the printing durability.

### (Evaluation of printing durability after burning treatment)

After washing with water the printing surfaces of the planographic printing plates obtained by development in the same manner as those in the above-mentioned printing durability evaluation, the printing surfaces were wiped with a burning surface conditioning solution BC-7 manufactured by Fuji Photo Film Co., Ltd. and then subjected to burning treatment at about 270°C for 2 minutes. Thereafter, the planographic printing plates were washed with water, and the printing surfaces were treated with a solution of Gum FP-2W manufactured by Fuji Photo Film Co., Ltd. diluted by two times by volume with water.

Then, in the same manner as in the above-mentioned printing durability evaluation, the planographic printing plates were used to carry out printing by black ink, DIC-GEOS (N) manufactured by Dainippon Ink and Chemicals, Inc. using a LITHRONE printing apparatus manufactured by Komori Corp.. The printing durability after burning treatment was evaluated, based on the number of printed sheets at the point where it could be observed visually that the density of the mat image had started to become lighter. Evaluation was made such that, the larger the number of printed sheets, the better the printing durability.

The above-described respective evaluation results are shown in Table 1.

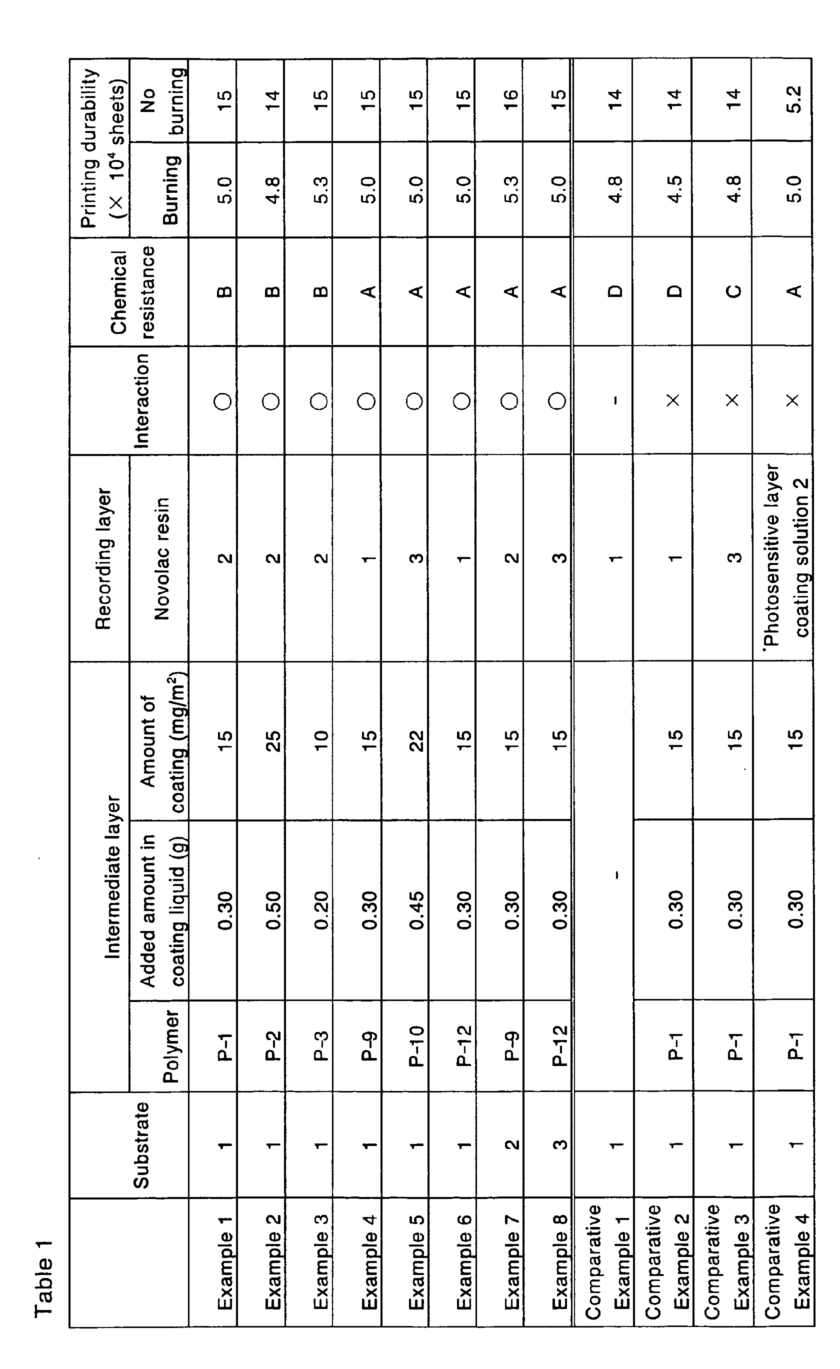

Each of the planographic printing plates in Examples 1 to 8 was obtained by exposing and developing each planographic printing plate precursor which uses an image recording material of the invention comprising a specific intermediate layer provided on an anodized aluminum substrate. The results in Table 1 show that each planographic printing plate in Examples 1 to 8 is excellent in both chemical resistance and printing durability, and the printing durability is remarkably improved by a burning treatment. Chemical resistance was poor in the planographic printing plate in Comparative Example 1 having no intermediate layer, and in the planographic printing plates in Comparative Examples 2 to 4 in which no interaction was confirmed between the polymer in the intermediate layer and photosensitive layer. Since the planographic printing plate in Comparative example 4 contains only a small amount of the novolac resin in the photosensitive layer, no effect for improving printing durability was observed by burning.

## Claims

1. An image recording material comprising:
a substrate;
an intermediate layer; and
a photosensitive layer containing a novolac phenol resin and a light to heat conversion agent and being recordable with an infrared laser,
wherein the intermediate layer and the photosensitive layer are sequentially provided on the substrate, and
the intermediate layer comprises a polymer having an acidic group, the polymer being capable of interacting with the novolac phenol resin contained in the photosensitive layer.

2. An image recording material according to claim 1, wherein the substrate firmly contacts with the photosensitive layer via the intermediate layer by an interaction between the acidic group of the polymer and the surface of the substrate, and by an interaction between the polymer and photosensitive layer.

3. An image recording material according to claim 1, wherein the intermediate layer is soluble in an alkaline developer.

4. An image recording material according to claim 1, wherein the polymer is a vinyl based polymer containing as a polymerization component a monomer having a carboxylic acid group in a side chain thereof, which polymer is represented by the following general formula (1) or (2): 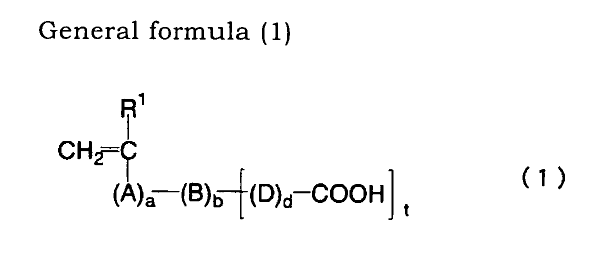 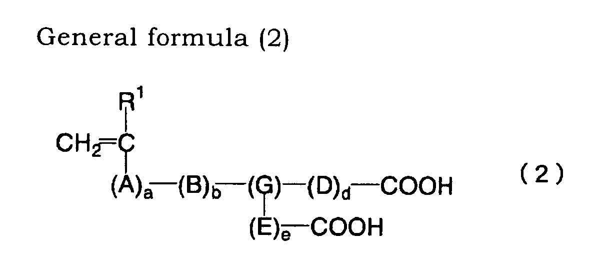 wherein A represents a divalent linking group; B represents an aromatic group or a substituted aromatic group, D and E independently represent divalent linking groups; G represents a trivalent linking group; the carboxylic acid group represented by -COOH may form an alkali metal salt or an ammonium salt; R¹ represents a hydrogen atom, an alkyl group or a halogen atom; a, b, d and e independently represent 0 or 1; and t represents an integer of 1 to 3.

5. An image recording material according to claim 1, wherein the polymer contains as a polymerization component a monomer represented by the following formula: 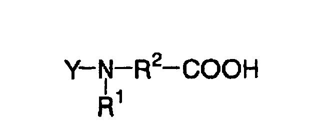 wherein Y represents a linking group which effects bonding of the monomer to the polymer main chain skeleton; R¹ represents a hydrogen atom or a hydrocarbon group; and R² represents a divalent hydrocarbon group.

6. An image recording material according to claim 1, wherein the polymer contains a monomer having an onium group.

7. An image recording material according to claim 1, wherein the polymer contains a monomer having a lactone group.

8. An image recording material according to claim 1, wherein the polymer contains a polyfunctional carboxylic acid monomer.

9. An image recording material according to claim 1, wherein the polymer contains a monomer having an acidic group, and the content of the monomer is not less than 5% by mole.

10. An image recording material according to claim 1, wherein the polymer has a weight average molecular weight in the range of 500 to 1,000,000.

11. An image recording material according to claim 10, wherein the polymer has a weight average molecular weight in the range of 1,000 to 500,000.

12. An image recording material according to claim 1, wherein the content of the polymer in the intermediate layer is in a range of 30 to 100% by mass, relative to the total solid content constituting the intermediate layer.

13. An image recording material at least comprising:
a substrate;
an intermediate layer; and
a photosensitive layer provided on the substrate,
wherein the intermediate layer includes a polymer having an acidic group and capable of interacting with a novolac phenol resin contained in the photosensitive layer,
the polymer contains at least one of a monomer having an onium group and a monomer having a lactone group as a copolymerization component, and
the photosensitive layer contains the novolac phenol resin and a light to heat conversion agent and is recordable with an infrared laser.

14. An image recording material according to claim 13, wherein the substrate firmly contacts with the photosensitive layer via the intermediate layer by an interaction between the acidic group of the polymer and the surface of the substrate, and by an interaction between the polymer and photosensitive layer.

15. An image recording material according to claim 13, wherein the intermediate layer firmly contacts with the substrate by an interaction between the surface of the substrate and at least one of the monomer having the onium group and the monomer having the lactone group.

16. An image recording material according to claim 13, wherein the photosensitive layer firmly contacts with the intermediate layer by an interaction between the photosensitive layer and at least one of the monomer having the onium group and the monomer having the lactone group.

17. An image recording material according to claim 13, wherein the intermediate layer is soluble in an alkaline developer.

18. An image recording material according to claim 13, wherein the polymer is a vinyl polymer containing as a polymerization component a monomer having a carboxylic acid group in a side chain thereof, which polymer is represented by following general formula (1) or (2). General formula (1)

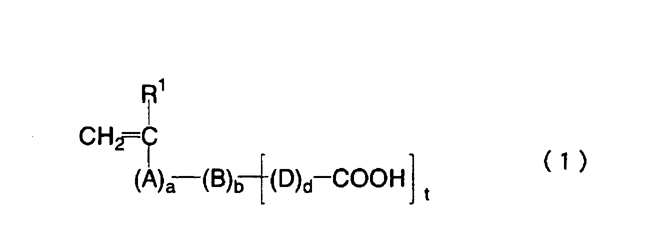

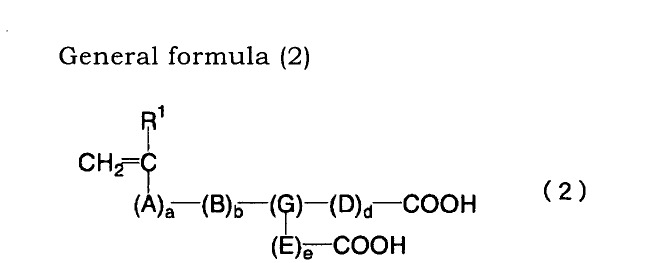

19. An image recording material according to claim 13, wherein the polymer is a vinyl polymer containing, as a polymerization component, a monomer represented by the following general formula (I): 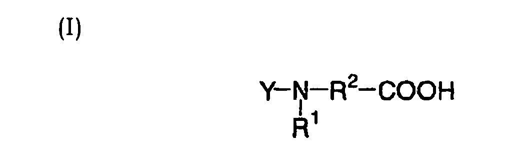 wherein Y represents a linking group to the polymer main chain frame; R¹ represents a hydrogen atom or a hydrocarbon group; and R² represents a divalent hydrocarbon group.

20. A planographic printing plate obtained by heat-treating a planographic printing plate precursor at 150 to 300°C after exposing the planographic printing plate precursor to an infrared laser and developing the precursor,
wherein the planographic printing plate precursor comprises a substrate, an intermediate layer, and a photosensitive layer containing a novolac phenol resin and a light to heat conversion agent and being recordable with an infrared laser,
the intermediate layer and the photosensitive layer are sequentially provided on the substrate, and
the intermediate layer comprises a polymer having an acidic group and capable of interacting with the novolac phenol resin contained in the photosensitive layer.

21. A planographic printing plate obtained by heat-treating a planographic printing plate precursor at 150 to 300°C after exposing the planographic printing plate precursor to an infrared laser and developing the precursor,
wherein the planographic printing plate precursor is an image recording material comprising at least a substrate, an intermediate layer provided on the substrate and a photosensitive layer,
the intermediate layer contains a polymer having an acidic group and capable of interacting with a novolac phenol resin contained in the photosensitive layer,
the polymer contains at least one of a monomer having an onium group and a monomer having a lactone group as a copolymerization component, and
the photosensitive layer contains the novolac phenol resin and a light to heat conversion agent and is recordable with an infrared laser.
